# EUROPÄISCHE PATENTSCHRIFT

(11) **EP 2 422 591 B1**
(45) Veröffentlichungstag und Bekanntmachung des Hinweises auf die Patenterteilung: **30.05.2018**
(21) Anmeldenummer: 10715712.5
(22) Anmeldetag: 22.04.2010
(51) Int. Cl.: H05K 3/00, B65G 49/00, C25D 17/06, H05K 13/00, H05K 3/06, H05K 1/03, H05K 3/24

(54) **VERFAHREN, HALTEMITTEL, VORRICHTUNG UND SYSTEM ZUM TRANSPORTIEREN EINES FLÄCHIGEN BEHANDLUNGSGUTES UND BE- ODER ENTLADEEINRICHTUNG**
METHOD, RETAINING MEANS, APPARATUS AND SYSTEM FOR TRANSPORTING A FLAT MATERIAL FEEDSTOCK, AND LOADING OR UNLOADING DEVICE
PROCÉDÉ, MOYEN DE RETENUE, DISPOSITIF ET SYSTÈME DE TRANSPORT D'UN PRODUIT PLAT À TRAITER, AINSI QUE DISPOSITIF DE CHARGEMENT ET DE DÉCHARGEMENT

(30) Priorität: 22.04.2009 DE 102009018393
(43) Veröffentlichungstag der Anmeldung: 29.02.2012
(73) Patentinhaber: Atotech Deutschland GmbH, 10553 Berlin (DE)
(72) Erfinder: KUNZE, Henry, 90530 Wendelstein (DE); THOMAS, Christian, 91058 Erlangen (DE)
(74) Vertreter: Banzer, Hans-Jörg
(86) Internationale Anmeldenummer: PCT/EP2010/002481
(87) Internationale Veröffentlichungsnummer: WO 2010/121815

(56) Entgegenhaltungen:
- DE-A1- 4 243 252
- DE-A1- 4 323 698
- DE-A1- 10 241 619
- DE-A1-102005 024 102
- DE-A1-102007 038 116
- DE-C2- 3 645 319
- DE-U1- 20 304 601

## Beschreibung

Die Erfindung betrifft ein Verfahren, Haltemittel, eine Vorrichtung und ein System zum Transportieren eines flächigen Behandlungsgutes für eine Anlage zur chemischen und/oder elektrochemischen Behandlung des Behandlungsgutes. Die Erfindung betrifft weiterhin eine Be- oder Entladeeinrichtung für eine derartige Anlage. Insbesondere betrifft die Erfindung derartige Verfahren und Vorrichtungen zum Transportieren von Behandlungsgut, das eine geringe Eigensteifigkeit aufweist, wie beispielsweise Folien. Die Erfindung betrifft auch derartige Verfahren und Vorrichtungen, bei denen eine Berührung zwischen einem zu behandelnden Nutzbereich des Behandlungsgutes und festen Elementen der Anlage weitgehend vermieden werden kann.

Bei der Bearbeitung von flächigem Behandlungsgut, wie beispielsweise Leiterplatten in der Leiterplattenindustrie, findet eine Behandlung des Behandlungsgutes häufig in einer nasschemischen Prozesslinie statt. In herkömmlichen Anlagen werden die Leiterplatten häufig auf Rollenbahnen aufgelegt und durch die Anlage transportiert. Für immer dünner werdendes Behandlungsgut, insbesondere für folienartiges Behandlungsgut, wird ein Transport durch Rollen- oder Walzenbahnen jedoch zunehmend schwierig, da das Behandlungsgut eine geringe Eigenstabilität aufweist oder aufgrund des geringen Gewichts pro Fläche durch Besprühen mit Behandlungs- oder Spülflüssigkeit bewegt oder verschoben werden kann. Weiterhin sind die Oberflächen mancher Substrate und/oder die in der Prozesslinie darauf aufgebrachten Materialien, beispielsweise Lacke, so empfindlich, dass sie bereits durch das Aufliegen auf den Rollen beschädigt werden könnten.

Aus der DE 10 2007 038 116 A1 sind eine Vorrichtung und ein Verfahren zum Transport von Substraten, insbesondere Leiterplatten, bekannt, bei der bzw. bei dem hintereinander liegende Leiterplatten mittels Haltebügeln zu einer Kette verbunden werden. Die Haltebügel erstrecken sich entlang der Breitenrichtung der Leiterplatten.

Die DE 203 04 601 U1 beschreibt eine Vorrichtung zum Transportieren von flexiblem Behandlungsmaterial. Dabei wird eine Spannung quer zur Transportrichtung des Flachmaterials aufgebracht. Zum Aufbringen der Zugspannung werden im Randbereich des Flachmaterials beidseitig angreifende, sich auf dem Flachmaterial abwälzende Zugmittel verwendet, die beispielsweise Klammern in Kombination mit Federn umfassen können. Die Klammern sind fest an Transportketten der Behandlungsvorrichtung angebracht.

Die DE 102 41 619 A1 beschreibt Vorrichtungen und Verfahren zur elektrolytischen Behandlung von Behandlungsgut, bei denen Kontaktleisten an zueinander gegenüberliegenden Seitenrändern des Behandlungsguts vorgesehen sind, um das Behandlungsgut elektrisch zu kontaktieren. Entsprechende Kontaktrahmen können in einer Durchlaufanlage verwendet werden.

Die DE 42 43 252 A1 beschreibt eine Vorrichtung zum Halten von Leiterplatten, die für eine Tauchbehandlung ausgestaltet ist

Die DE 10 2007 038 116 A1 beschreibt ein Haltemittel und eine Vorrichtung und Verfahren zum Transport von Substraten. Dabei halten die Haltemittel das Substrat entlang einem Bereich des Substrats, der sich quer zu einer Transportrichtung erstreckt. Die Haltemittel weisen abgewinkelte Halteabschnitte auf, die mit einer Innenwand der Vorrichtung in Eingriff sind und mit einer Kette bewegt werden.

Der Erfindung liegt die Aufgabe zugrunde, ein Verfahren, Haltemittel, eine Vorrichtung und ein System zum Transportieren eines flächigen Behandlungsgutes sowie eine Be- oder Entladeeinrichtung für eine Anlage der eingangs genannten Art anzugeben, die bzw. das einen sicheren Transport von Behandlungsgut erlaubt, insbesondere von Behandlungsgut mit geringer Eigenstabilität, beispielsweise von folienartigen Leiterplatten, oder mit einer empfindlichen Oberfläche.

Erfindungsgemäß wird die Aufgabe gelöst durch ein Verfahren, Haltemittel, eine Vorrichtung und ein System zum Transportieren eines flächigen Behandlungsgutes für eine Anlage zur chemischen und/oder elektrochemischen Behandlung des Behandlungsgutes mit den in den unabhängigen Ansprüchen angegebenen Merkmalen. Die abhängigen Ansprüche definieren bevorzugte und vorteilhafte Ausführungsformen der Erfindung.

Das Verfahren zum Transportieren eines flächigen Behandlungsgutes, bei dem das Behandlungsgut in einer Transportebene in einer Transportrichtung transportiert wird, sieht vor, dass Haltemittel an dem Behandlungsgut angebracht werden, die das Behandlungsgut an mindestens zwei Punkten eines Randbereiches des Behandlungsgutes halten, der beim Transportieren des Behandlungsgutes entlang der Transportrichtung gerichtet ist. Die Haltemittel werden in der Transportrichtung bewegt, um das Behandlungsgut zu transportieren. Wenigstens während eines Abschnitts des Transportierens des Behandlungsgutes wird auf wenigstens einen Bereich des Behandlungsgutes eine Kraft mit einer Kraftkomponente, die in der Transportebene liegt und quer zu der Transportrichtung gerichtet ist, ausgeübt. Die das Behandlungsgut haltenden Haltemittel werden lösbar mit einer Transportvorrichtung der Anlage gekoppelt.

Da bei dem Verfahren das Behandlungsgut an Haltemitteln gehaltert und durch die Bewegung der Haltemittel bewegt wird, ist es nicht nötig, das Behandlungsgut selbst mit Rollen, Walzen oder ähnlichen Antriebsmitteln in Kontakt zu bringen, um es zu transportieren. Durch das Ausüben der Kraft mit der Kraftkomponente, die in der Transportebene liegt und quer zu der Transportrichtung gerichtet ist, kann das Behandlungsgut in der Breitenrichtung, d.h. in der Richtung rechtwinklig zu der Transportrichtung und in der Transportebene, gespannt werden. Auf diese Weise kann Behandlungsgut mit geringer Eigenstabilität und/oder mit empfindlichen Oberflächen, wie Leiterfolien, sicher transportiert werden.

Das Verfahren kann so ausgestaltet sein, dass die Haltemittel zunächst an dem Behandlungsgut angebracht und erst anschließend mit einer Transportvorrichtung der Anlage gekoppelt werden, um die Haltemittel mit dem daran gehalterten Behandlungsgut durch die Anlage zu transportieren. Die Haltemittel sind insbesondere separat von der Anlage, insbesondere dem Transportsystem, ausgebildet. Die Haltemittel sind nach Ausführungsformen insbesondere nicht permanent mit dem Transportsystem der Anlage verbunden.

Das Verfahren kann derart ausgestaltet sein, dass das Behandlungsgut durch mindestens zwei unmittelbar aufeinander folgende unterschiedliche Behandlungsstationen zur chemischen oder elektrochemischen Behandlung des Behandlungsgutes transportiert wird, ohne dass dazwischen die Haltemittel von dem Behandlungsgut entfernt werden. Die unterschiedlichen Behandlungsstationen unterscheiden sich durch unterschiedliche Inhaltsstoffe oder Konzentrationen der Behandlungslösung.

Die Kraft mit der Kraftkomponente, die auf den wenigstens einen Bereich des Behandlungsgutes ausgeübt wird, kann so gewählt werden, dass Auslenkungen des Behandlungsgutes aus der Transportebene klein sind, aber das Behandlungsgut nicht überdehnt wird. Die Kraft mit der Kraftkomponente kann weiterhin so gewählt werden, dass beim Transportieren des Behandlungsgutes durch eine Behandlungsstation der Anlage eine Oberseite und eine Unterseite des Behandlungsgutes einen gleichen Abstand von zur Behandlung der Ober- bzw. Unterseite des Behandlungsgutes vorgesehenen festen Elementen der Behandlungsstation aufweisen. Die Kraft mit der Kraftkomponente kann weiterhin so gewählt werden, dass dieser Abstand über die Breite des Behandlungsgutes konstant ist.

Die Kraft kann über die Haltemittel auf den Randbereich des Behandlungsgutes ausgeübt werden. Dazu kann auf die Haltemittel wenigstens während des Abschnitts des Transportierens des Behandlungsgutes, d.h. zumindest über einen Abschnitt des Transportweges des Behandlungsgutes in der Anlage, eine Kraft in einer Richtung quer zu der Transportrichtung und in der Transportebene ausgeübt werden.

Das Behandlungsgut kann an einem weiteren entlang der Längsrichtung des Behandlungsgutes gerichteten Randbereich von weiteren Haltemitteln gehalten werden. Auf die Haltemittel und die weiteren Haltemittel können Kräfte in entgegengesetzte Richtungen, also voneinander weg gerichtete Kräfte, ausgeübt werden, die quer zur Transportrichtung gerichtet sind.

Die Kraft, die auf die Haltemittel bzw. die Haltemittel und die weiteren Haltemittel wirkt, kann abhängig von Eigenschaften des Behandlungsgutes gewählt werden. Beispielsweise kann die Kraft abhängig von einer maximalen erlaubten Verformung des Behandlungsgutes gewählt werden. Die Kraft kann auch abhängig von der Dicke und ggf. weiteren Materialparametern des Behandlungsgutes so gewählt werden, dass die durch lotrecht zur Transportebene wirkende Kräfte hervorgerufene Verformung oder Auslenkung des Behandlungsgutes aus der Transportebene heraus kleiner als ein Schwellenwert bleibt.

Die Haltemittel können darüber hinaus eingerichtet sein, um das Behandlungsgut parallel zu der Transportrichtung zu spannen. Dazu können unterschiedliche und gegeneinander beispielsweise mechanisch vorgespannte Abschnitte der Haltemittel das Behandlungsgut an entlang der Längsrichtung beabstandeten Punkten halten, beispielsweise in der Umgebung einer vorderen und einer hinteren Ecke des Behandlungsgutes entlang des in Längsrichtung angeordneten Randes.

Der Randbereich, an dem die Haltemittel das Behandlungsgut halten, kann in der Breitenrichtung des Behandlungsgutes, d.h. quer zu der Transportrichtung, eine maximale Ausdehnung aufweisen, die kleiner als eine Breite des Behandlungsgutes ist. So kann ein verhältnismäßig großer Bereich des Behandlungsgutes für die chemische oder elektrochemische Behandlung in der Anlage zugänglich bleiben.

Die Haltemittel können nicht nur zur mechanischen Halterung, sondern auch zum elektrischen Kontaktieren des Behandlungsgutes verwendet werden. Dazu können die Haltemittel mit einer Stromkontaktierung, beispielsweise in der Form einer Klammer oder eines Rades, in elektrisch leitenden Kontakt gebracht werden, wenn ein elektrochemischer Behandlungsschritt durchgeführt werden soll.

Beim Durchlaufen einer nasschemischen Behandlungsstation kann das an den Haltemitteln gehalterte Behandlungsgut derart durch die Behandlungsstation transportiert werden, dass die Haltemittel an einem Bereich der Behandlungsstation vorbeigeführt werden, in dem ein Behandlungsfluid auf das Behandlungsgut aufgebracht wird. Da die Haltemittel den entlang der Transportrichtung gerichteten Randabschnitt des Behandlungsgutes halten, können die Haltemittel durch geeignete Ausgestaltung der Behandlungsstation seitlich an dem Bereich vorbeigeführt werden, in dem das Behandlungsfluid auf das Behandlungsgut aufgebracht wird. Wenn das Behandlungsgut gespült und/oder getrocknet wird, können die Haltemittel zusammen mit dem daran gehalterten Behandlungsgut durch den Bereich zum Spülen und/oder Trocknen des Behandlungsgutes geführt werden, so dass auch die Haltemittel gespült und/oder getrocknet werden. Es können auch Behandlungsstationen vorgesehen sein, in denen selektiv die Haltemittel behandelt werden. Beispielsweise kann eine Behandlungsstation ausgestaltet sein, um die Haltemitteln, nicht aber den Nutzbereich des Behandlungsgutes, mit einem Behandlungsfluid anzuströmen.

Das Behandlungsgut kann ein Behandlungsgut mit geringer Eigensteifigkeit, beispielsweise eine Folie, sein. Das Behandlungsgut kann auch ein Endlosmaterial sein.

Die nach einem Aspekt der Erfindung vorgesehenen Haltemittel sind eingerichtet, um das Behandlungsgut in einem Randbereich des Behandlungsgutes an mindestens zwei Punkten zu halten. Die Haltemittel sind für eine lösbare Kopplung mit einer Transportvorrichtung einer Anlage zur chemischen und/oder elektrochemischen Behandlung des Behandlungsgutes zum Transportieren des Behandlungsgutes entlang einer Transportrichtung eingerichtet und so ausgestaltet, dass sie in einem mit der Transportvorrichtung gekoppelten Zustand das Behandlungsgut derart halten, dass sich der Randbereich des Behandlungsgutes, in dem die Haltemittel das Behandlungsgut halten, entlang der Transportrichtung erstreckt.

Derart ausgestaltete Haltemittel können den beim Transportieren des Behandlungsgutes in Transportrichtung gerichteten Randbereich des Behandlungsgutes stabilisieren.

Die Haltemittel können so ausgestaltet sein, dass sie eine Halteschiene mit einer Längsachse umfassen. Die Halteschiene kann ausgebildet sein, um derart versteifend auf das Behandlungsgut zu wirken, dass die Halteschiene ein Biegen oder Knicken des Behandlungsgutes um eine erste und zweite Achse, die jeweils senkrecht zu der Längsachse der Halteschiene gerichtet sind, unterdrückt. Die Halteschiene kann so ausgebildet sein, dass in einem mit der Transportvorrichtung gekoppelten Zustand die Längsachse der Halteschiene parallel zu der Transportrichtung ist. In dem mit der Transportvorrichtung gekoppelten Zustand können die Haltemittel somit eingerichtet sein, um auf das Behandlungsgut wirkende Biegekräfte derart aufzunehmen, dass einem Biegen oder Knicken des Behandlungsgutes um eine erste und zweite Achse, die jeweils senkrecht zu der Transportrichtung sind, entgegengewirkt wird.

Die Haltemittel können ein erstes Halteteil und ein zweites Halteteil umfassen, die einen Schließzustand zum Halten des Behandlungsgutes und einen Offenzustand zum Einfügen des Behandlungsgutes aufweisen. Das erste und zweite Halteteil können beispielsweise als separate Teile ausgebildet sein, die im Offenzustand vollständig voneinander getrennt sein können. Das erste und zweite Halteteil können eingerichtet sein, um in dem Schließzustand das Behandlungsgut wenigstens durch einen Kraftschluss zu haltern. Alternativ oder zusätzlich kann das Behandlungsgut auch formschlüssig gehalten werden. Die Haltemittel können Kraftmittel umfassen, die in dem Schließzustand der Haltemittel eine attraktive Kraft zwischen dem ersten und zweiten Halteteil ausüben. Die Kraftmittel können Magnete an oder in den Halteteilen umfassen.

Die Haltemittel können derart ausgebildet sein, dass sie in dem mit der Transportvorrichtung gekoppelten Zustand das Behandlungsgut in der Richtung rechtwinklig zu der Transportrichtung über eine Entfernung übergreifen, die kleiner als eine Breite des Behandlungsgutes ist. So kann ein verhältnismäßig großer Bereich des mit den Haltemitteln gehalterten Behandlungsgutes für die chemische oder elektrochemische Behandlung in der Anlage zugänglich bleiben.

Die Haltemittel können eine Halteschiene umfassen, in der Flüssigkeitsdurchlässe ausgebildet sind. Derart ausgestaltete Haltemittel erlauben, dass durch die Haltemittel Flüssigkeit, beispielsweise Behandlungs- oder Spülflüssigkeit, von dem Behandlungsgut abgeführt werden kann.

Die Haltemittel können ausgebildet sein, um eine quer zu der Transportrichtung beweglich angeordnete Antriebsrolle oder Antriebswalze der Transportvorrichtung quer zur Transportrichtung zu verschieben. Dazu können die Haltemittel beispielsweise eine abgeschrägte Seite oder ein abgefastes Ende aufweisen, die bzw. das die Antriebsrolle oder Antriebswalze erfasst und quer zur Transportrichtung verschiebt, während sich die Haltemittel relativ zur Antriebsrolle bewegen.

Die Haltemittel können eingerichtet sein, um Behandlungsgut elektrisch zu kontaktieren. Dazu können die Haltemittel mindestens eine elektrisch leitende Kontaktfläche, die eingerichtet ist, um das Behandlungsgut zu berühren, und eine weitere elektrisch leitende Kontaktfläche umfassen, die so angeordnet ist, dass sie mit einem externen Kontaktelement gekoppelt werden kann, wenn die Haltemittel das Behandlungsgut halten. Die elektrisch leitende Kontaktfläche und die weitere elektrisch leitende Kontaktfläche können durch einen in den Haltemitteln vorgesehenen Leiterabschnitt elektrisch leitend verbunden sein. Die weitere elektrisch leitende Kontaktfläche kann zwei Abschnitte aufweisen, die an entgegengesetzten Seiten der Haltemittel angeordnet sind, wenn die Haltemittel das Behandlungsgut halten. Durch Anpressen von zwei Kontaktelementen an die zwei Abschnitte kann ein guter elektrischer Kontakt mit dem Behandlungsgut sowie eine gute mechanische Halterung des Behandlungsgutes in den Haltemitteln erreicht werden.

Die nach einem Aspekt der Erfindung vorgesehene Vorrichtung zum Transportieren eines mit Haltemitteln entlang einem Randbereich gehalterten flächigen Behandlungsgutes für eine Anlage zur chemischen und/oder elektrochemischen Behandlung des Behandlungsgutes umfasst Transportmittel, die lösbar mit den Haltemitteln koppelbar sind und die eingerichtet sind, um die Haltemittel mit dem daran gehalterten Behandlungsgut in einer Transportrichtung zu bewegen. Die Vorrichtung ist eingerichtet, um wenigstens während eines Abschnitts des Transportierens des Behandlungsgutes auf wenigstens einen Bereich des Behandlungsgutes eine Kraft mit einer Kraftkomponente, die in einer Transportebene liegt und quer zu der Transportrichtung gerichtet ist, auszuüben.

Da die Transportmittel der Vorrichtung mit den Haltemitteln gekoppelt werden können, die das Behandlungsgut halten, ist es nicht nötig, das Behandlungsgut selbst mit Rollen, Walzen oder ähnlichen Antriebsmitteln in Kontakt zu bringen, um es zu transportieren. Durch das Ausüben der Kraft mit der Kraftkomponente, die in der Transportebene liegt und quer zu der Transportrichtung gerichtet ist, kann das Behandlungsgut in der Breitenrichtung, d.h. in der Richtung rechtwinklig zur Transportrichtung, gespannt werden.

Die Vorrichtung kann Spannmittel zum Ausüben einer Kraft auf die Haltemittel in einer Richtung quer zu der Transportrichtung und in der Transportebene aufweisen. Die Spannmittel können ein quer zu der Transportrichtung bewegliches Loslager umfassen, das zum Führen der Haltemittel eingerichtet ist. Das Loslager kann an einer Antriebswelle angebracht sein. Kraftmittel, beispielsweise ein Paar von Magneten oder ein federelastisches Element, können vorgesehen sein, um auf das Loslager eine Kraft quer zu der Transportrichtung auszuüben. Diese Ausgestaltung erlaubt es, über das Loslager, in dem die Haltemittel geführt sind, eine Kraft auf die Haltemittel auszuüben, mit der wiederum das Behandlungsgut in der Breitenrichtung gespannt werden kann.

Das Behandlungsgut, das von der Vorrichtung transportiert wird, kann entlang einem weiteren Randbereich mit weiteren Haltemitteln gehaltert sein. Die Vorrichtung kann weitere Spannmittel umfassen, die eingerichtet sind, um auf die weiteren Haltemittel in einer Richtung quer zu der Transportrichtung und in der Transportebene eine Kraft auszuüben. Insbesondere können die Spannmittel und die weiteren Spannmittel eingerichtet sein, um auf die Haltemittel und die weiteren Haltemittel Kräfte in entgegengesetzte Richtungen auszuüben. Die weiteren Spannmittel können ein weiteres Loslager umfassen, auf das eine Kraft quer zu der Transportrichtung ausgeübt wird.

Das nach einem Aspekt der Erfindung vorgesehene System zum Transportieren eines von Haltemitteln entlang einem Randbereich gehaltenen flächigen Behandlungsgutes für eine Anlage zur chemischen und/oder elektrochemischen Behandlung des Behandlungsgutes umfasst eine Vorrichtung zum Transportieren des Behandlungsgutes nach einem Ausführungsbeispiel und Haltemittel zum Halten des Behandlungsgutes, die mit dem Transportmittel der Vorrichtung lösbar gekoppelt sind. Die Haltemittel können als Haltemittel nach einem Ausführungsbeispiel ausgebildet sein.

Nach einem weiteren Aspekt umfasst die Anlage eine Be- oder Entladeeinrichtung für eine Anlage zur chemischen und/oder elektrochemischen Behandlung des Behandlungsgutes, die eine Vorrichtung zum Transportieren eines von Haltemitteln entlang einem Randbereich gehaltenen flächigen Behandlungsgutes aufweist. Die Be- oder Entladeeinrichtung kann als Belader oder als Entlader für eine derartige Anlage verwendet werden. Die Be- oder Entladeeinrichtung ist eingerichtet, um die Haltemittel zwischen einem Schließzustand zum Halten des Behandlungsgutes und einem Offenzustand zu überführen und umfasst eine Stützeinrichtung zum Abstützen des Behandlungsgutes, wenn die Haltemittel in den Offenzustand überführt sind.

Eine derartige Be- oder Entladeeinrichtung erlaubt es, die Haltemittel an dem Behandlungsgut anzubringen, um das von den Haltemitteln gehaltene Behandlungsgut anschließend der Anlage zur Behandlung zuzuführen, oder die Haltemittel nach der Behandlung in der Anlage von dem Behandlungsgut zu entfernen. Die Stützeinrichtung stützt das Behandlungsgut in dem Offenzustand der Haltemittel. Die Stützeinrichtung kann beispielsweise eine vertikal verstellbare Lochplatte oder eine Luftdüse zum Erzeugen eines Luftpolsters umfassen, die bzw. das das Behandlungsgut stützen kann.

Die Be- oder Entladeeinrichtung kann eingerichtet sein, um die Haltemittel in dem Schließzustand zu empfangen, von dem Schließzustand in den Offenzustand und anschließend zurück in den Schließzustand zu überführen und in dem Schließzustand auszugeben.

Die Be- oder Entladeeinrichtung kann erste Eingriffsmittel für einen Eingriff mit einem ersten Halteteil der Haltemittel und zweite Eingriffsmittel für einen Eingriff mit einem zweiten Halteteil der Haltemittel umfassen. Die ersten und zweiten Eingriffsmittel können beispielsweise jeweils eine profilierte Fläche umfassen, die in eine komplementäre Fläche des ersten Halteteils bzw. des zweiten Halteteils formschlüssig eingreifen. Bewegungsmittel zum Herbeiführen einer Relativbewegung der ersten Eingriffsmittel und der zweiten Eingriffsmittel können vorgesehen sein, um das erste Halteteil und das zweite Halteteil zwischen dem Offenzustand und dem Schließzustand zu überführen.

Die Bewegungsmittel können eingerichtet sein, um eine als Funktion des bei der Relativbewegung zurückgelegten Weges veränderliche Kraft auszuüben. Beispielsweise kann zunächst eine verhältnismäßig große Kraft ausgeübt werden, bis die Halteteile um einen vorgegebenen Abstand voneinander getrennt sind. Die von den Bewegungsmittel ausgeübte Kraft kann anschließend einen kleineren Wert annehmen, um die Halteteile noch weiter voneinander zu trennen. Die verhältnismäßig große Kraft kann über einen Weg ausgeübt werden, der kleiner als der Weg ist, über den die kleinere Kraft ausgeübt wird.

Ausführungsbeispiele der Erfindung erlauben es, Behandlungsgut, insbesondere auch Behandlungsgut mit geringer Eigenstabilität, wie beispielsweise Folien, sicher durch eine Anlage zur chemischen und/oder elektrochemischen Behandlung des Behandlungsgutes zu transportieren.

Die Erfindung wird nachfolgend anhand bevorzugter oder vorteilhafter Ausführungsbeispiele unter Bezugnahme auf die beigefügten Zeichnungen näher erläutert.
Fig. 1 ist eine schematische Darstellung eines Transports von Behandlungsgut durch eine Anlage zur Behandlung des Behandlungsgutes nach einem Ausführungsbeispiel.
Fig. 2 ist eine Perspektivansicht einer mit Haltemitteln nach einem Ausführungsbeispiel gehalterten Folie.
Fig. 3 ist eine Perspektivansicht einer Transportvorrichtung nach einem Ausführungsbeispiel.
Fig. 4 ist eine Seitenansicht eines Abschnitts der Transportvorrichtung von Fig. 4.
Fig. 5 ist eine Perspektivansicht einer Behandlungsstation einer Anlage zur Behandlung des Behandlungsgutes mit einer Transportvorrichtung nach einem Ausführungsbeispiel.
Fig. 6 ist eine Querschnittsansicht von Haltemitteln nach einem Ausführungsbeispiel.
Fig. 7A und 7B sind Draufsichten des ersten bzw. zweiten Halteteils der Haltemittel von Fig. 6.
Fig. 8 ist eine schematische, teilweise abgebrochene Ansicht von Haltemitteln nach einem weiteren Ausführungsbeispiel.
Fig. 9 ist eine Perspektivansicht einer Beladeeinrichtung für eine Anlage nach einem Ausführungsbeispiel.
Fig. 10 ist eine Perspektivansicht einer Puffereinrichtung der in Fig. 1 dargestellten Anlage.
Fig. 11 ist eine Draufsicht von Endabschnitten benachbarter Haltemittel nach einem Ausführungsbeispiel.

Richtungs- oder Positionsangaben, die sich auf das Behandlungsgut beziehen, werden konventionsgemäß in Bezug auf die Transportrichtung angegeben. Die Richtung, die beim Transportieren des Behandlungsgutes parallel bzw. antiparallel zur Transportrichtung ist, wird als Längsrichtung, die in der Transportebene liegende Richtung orthogonal zur Transportrichtung als Breitenrichtung des Behandlungsgutes bezeichnet.

Unter einer lösbaren Kopplung von Elementen oder Einrichtungen ist eine derartige Kopplung zu verstehen, die es erlaubt, die Elemente oder Einrichtungen voneinander zu trennen, ohne die Elemente oder Einrichtungen zu beschädigen oder zu zerstören. Unter einer lösbaren Kopplung zwischen Haltemitteln und Behandlungsgut wird somit eine Kopplung verstanden, bei der die Haltemittel von dem Behandlungsgut entfernt werden können, ohne die Haltemittel oder das Behandlungsgut zu zerstören oder so zu beschädigen, dass sie in ihrer Funktion beeinträchtigt sind. Unter einer lösbaren Kopplung zwischen Haltemitteln und Transportvorrichtung wird eine Kopplung verstanden, bei der die Haltemittel von der Transportvorrichtung entfernt werden können, ohne die Haltemittel oder die Transportvorrichtung zu zerstören oder so zu beschädigen, dass sie in ihrer Funktion beeinträchtigt sind.

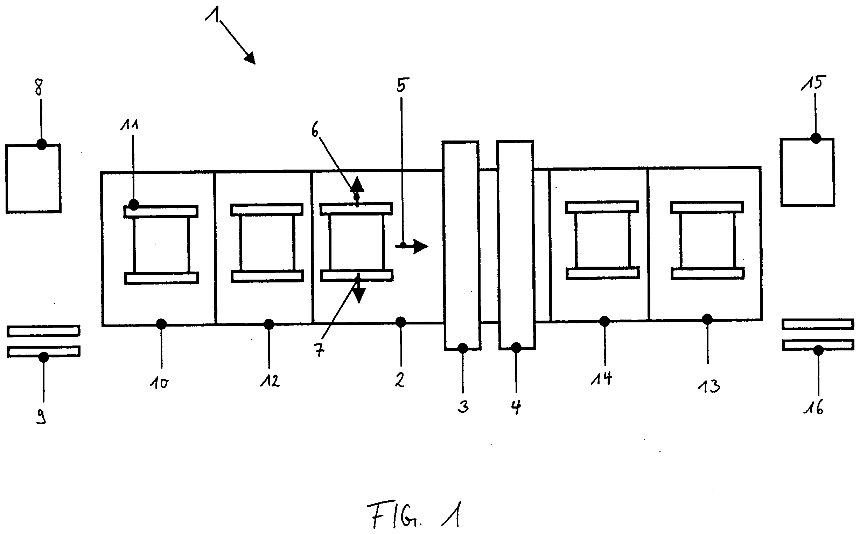

Fig. 1 zeigt schematisch eine Anlage 1 zum chemischen und/oder elektrochemischen Behandeln von flächigem Behandlungsgut, das beispielsweise in Form von dünnen Platten oder Folien ausgebildet sein kann. Die Anlage 1 umfasst eine Prozesslinie 2 mit mehreren Behandlungsstationen, an denen das Behandlungsgut beispielsweise einer chemischen und/oder elektrochemischen Behandlung unterzogen, gespült oder getrocknet wird. Behandlungsstationen 3, 4 sind schematisch dargestellt. Das Behandlungsgut wird in der Prozesslinie 2 in einer Transportrichtung 5 transportiert und so den Behandlungsstationen 3, 4 zugeführt. Auch wenn bei der Anlage 1 eine Prozesslinie 2 mit zwei Behandlungsstationen 3, 4 dargestellt ist, kann allgemein eine beliebige Anzahl von Behandlungsstationen vorgesehen werden, die für die jeweilige Anwendung entsprechend angepasst sind. An den Behandlungsstationen kann bzw. können dem Behandlungsgut beispielsweise eines oder mehrere von einem Behandlungsfluid, elektrischem Strom, Energie, Impuls oder Strahlung zugeführt werden, oder das Behandlungsgut kann in Schwingung versetzt werden etc.

Wie noch ausführlicher beschrieben werden wird, wird das Behandlungsgut an einem Randbereich oder an mehreren Randbereichen mit Haltemitteln gehaltert. Die Haltemittel sind so ausgestaltet und werden so geführt, dass die Längsränder des Behandlungsgutes, d.h. die parallel zu der Transportrichtung verlaufenden Ränder des Behandlungsgutes, in einer Ebene oder im Wesentlichen in einer Ebene liegen, die als Transportebene des Behandlungsgutes bezeichnet wird.

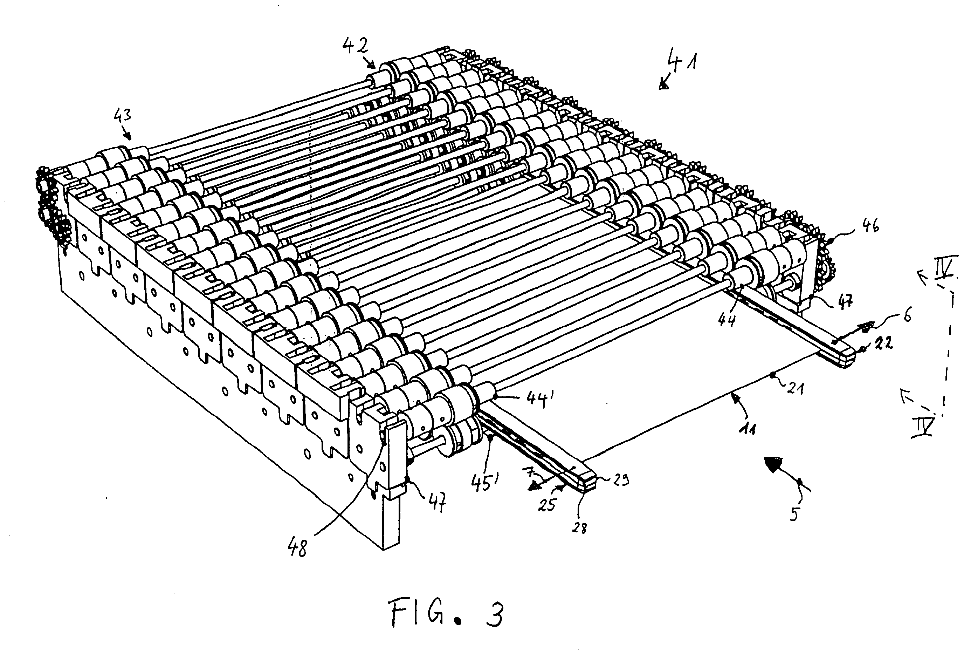

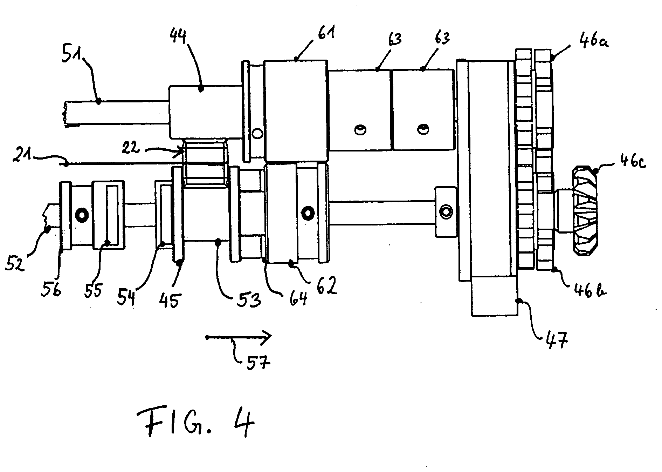

Vorrichtungen und Verfahren nach verschiedenen Ausführungsbeispielen erlauben es, Behandlungsgut mit geringer Eigensteifigkeit so zu halten und zu transportieren, dass die Abweichungen der verschiedenen Bereiche des Behandlungsgutes von der Transportebene klein bleiben. Die Bezugnahme auf einen "Transport des Behandlungsgutes in einer Transportebene" schließt allerdings nicht aus, dass einzelne Abschnitte oder Bereiche des Behandlungsgutes aus der Transportebene ausgelenkt sein können, während das Behandlungsgut transportiert wird. So kann beispielsweise die auf das Behandlungsgut wirkende Schwerkraft, ein Anströmen des Behandlungsgutes mit Fluid oder dergleichen zu einer Auslenkung von Bereichen des Behandlungsgutes aus der Transportebene führen. Das Behandlungsgut kann beispielsweise in einer horizontalen Transportebene transportiert werden. Zum Transportieren des Behandlungsgutes durch die Prozesslinie 2 ist die Anlage 1 mit einer Transportvorrichtung ausgestattet. Ein Ausführungsbeispiel für eine Transportvorrichtung, die zum Transportieren des Behandlungsgutes bei der in Fig. 1 schematisch dargestellten Anlage verwendet werden kann, wird unter Bezugnahme auf Fig. 3 und 4 näher beschrieben werden.

Um das Behandlungsgut in der Prozesslinie 2 der Anlage 1 zu transportieren, werden die Haltemittel lösbar an dem Behandlungsgut angebracht. Die Haltemittel werden wieder von dem Behandlungsgut abgenommen bzw. entfernt, nachdem das Behandlungsgut durch die Prozesslinie 2 transportiert wurde.

Die Anlage 1 umfasst weiterhin eine Beladeeinrichtung 10 bzw. einen Belader 10. Der Beladeeinrichtung 10 wird das zu behandelnde Behandlungsgut von einem entsprechenden Vorrat an zu behandelndem Behandlungsgut 8 zugeführt, beispielsweise unter Verwendung eines (in Fig. 1 nicht dargestellten) Roboters oder dergleichen. Der Beladeeinrichtung 10 werden weiterhin Haltemittel von einem Vorrat von Haltemitteln 9 zugeführt. Die Beladeeinrichtung bringt die Haltemittel an einem Randbereich des Behandlungsgutes an, so dass die Haltemittel das Behandlungsgut an mehreren Punkten an dem Randbereich halten. Wie noch näher erläutert werden wird, halten die Haltemittel das Behandlungsgut entlang einem Randabschnitt an dem parallel zur Transportrichtung gerichteten Rand des Behandlungsgutes. Die Haltemittel können das Behandlungsgut an mehreren Punkten oder Bereichen in dem Randabschnitt halten, die beabstandet oder durchgängig in dem Randabschnitt angeordnet sind. Bei einem Ausführungsbeispiel halten die Haltemittel das Behandlungsgut wenigstens in einer Umgebung der beiden Ecken des Behandlungsgutes, die den sich parallel zur Transportrichtung erstreckenden Randbereich des Behandlungsgutes begrenzen. Bei einem weiteren Ausführungsbeispiel halten die Haltemittel das Behandlungsgut wenigstens in einer Umgebung der beiden Ecken des Behandlungsgutes, die den sich parallel zur Transportrichtung erstreckenden Randbereich des Behandlungsgutes begrenzen, und in einem dazwischen angeordneten zentralen Abschnitt des Randbereiches.

Die Anlage 1 kann weiterhin eine Puffereinrichtung 12 aufweisen, die in Transportrichtung der Beladeeinrichtung 10 nachgeordnet und der Prozesslinie 2 vorgeordnet ist. Die Puffereinrichtung 12 empfängt das von den Haltemitteln gehalterte Behandlungsgut 11 von der Beladeeinrichtung 10. Die Puffereinrichtung 12 transportiert das gehalterte Behandlungsgut 11 weiter zu der Prozesslinie 2 und kann dabei so eingerichtet sein, dass sie das mit den Haltemitteln gehalterte Behandlungsgut 11 auf eine Geschwindigkeit beschleunigt oder abbremst, die der Anfangsgeschwindigkeit des Behandlungsgutes 11 in der Prozesslinie 2 entspricht. Weitere Funktionen können in die Puffereinrichtung 12 integriert sein. Beispielsweise kann die Puffereinrichtung 12 ausgestaltet sein, um das gehalterte Behandlungsgut 11 in der Richtung quer zu der Transportrichtung zu spannen. Die Puffereinrichtung 11 kann weiterhin verschiedene Sensoren und steuerbare Antriebselemente aufweisen, um den Abstand zwischen aufeinanderfolgenden Substraten oder Behandlungsgütern einzustellen.

Beim Transportieren des Behandlungsgutes in der Prozesslinie 2 greift die Transportvorrichtung der Anlage 1 an die Haltemittel an, die das Behandlungsgut halten. Die Transportvorrichtung bewegt die Haltemittel, um das daran gehalterte Behandlungsgut in der Transportrichtung 5 zu bewegen.

Während das Behandlungsgut in der Prozesslinie 2 transportiert wird, werden auf die parallel zur Transportrichtung verlaufenden Randbereiche des Behandlungsgutes, d.h. auf die Längsränder, Kräfte mit Kraftkomponenten 6, 7 ausgeübt. Die Kraftkomponenten 6, 7 sind so gerichtet, dass sie in der Transportebene liegen und rechtwinklig bzw. quer zur Transportrichtung gerichtet sind. Die Kraftkomponenten 6, 7, die auf die beiden parallel zur Transportrichtung verlaufenden Randabschnitte des Behandlungsgutes wirken, haben denselben Betrag und sind entgegengesetzt zueinander gerichtet. Der Betrag der Kraftkomponenten 6, 7 kann dabei so gewählt werden, dass die Kraftkomponenten 6, 7 das Behandlungsgut spannen. Der Betrag der Kraftkomponenten 6, 7 kann weiterhin so gewählt werden, dass die Kraftkomponenten 6, 7 das Behandlungsgut über seine Breite hinweg nahe an oder in der Transportebene halten, ohne das Behandlungsgut zu überdehnen. Der Betrag der Kraftkomponenten 6, 7 kann weiterhin so gewählt werden, dass die Oberseite und die Unterseite des Behandlungsgutes einen über die Breite des Behandlungsgutes im Wesentlichen konstanten Abstand zu festen Elementen von Behandlungsstationen aufweisen, die zur Behandlung der Ober- bzw. Unterseite vorgesehen sind.

Die Anlage 1 weist weiterhin ein Entladeeinrichtung 13 bzw. einen Entlader 13 auf, der das behandelte Behandlungsgut empfängt. Zwischen der Prozesslinie 2 und der Entladeeinrichtung 13 kann eine weitere Puffereinrichtung 14 vorgesehen sein, der das behandelte Behandlungsgut von der Prozesslinie 2 zugeführt wird und die das behandelte Behandlungsgut der Entladeeinrichtung 13 zuführt. Die Entladeeinrichtung 13 entfernt die Haltemittel von dem Behandlungsgut. Das behandelte Behandlungsgut 15 kann aus der Vorrichtung 1 entnommen und anschließend einer weiteren Verarbeitung zugeführt werden.

Nachdem die Haltemittel nach der Behandlung des Behandlungsgutes entfernt wurden, können auch die Haltemittel 16 aus der Vorrichtung 1 entfernt und zum Haltern eines weiteren Behandlungsgutes wiederverwendet werden. Gegebenenfalls können die Haltemittel 16 nach einmaligem oder mehrmaligem Durchlaufen der Anlage 1 einem Reinigungsverfahren unterzogen werden, um Ablagerungen von den Haltemitteln 16 zu entfernen, die sich bei dem vorhergehenden Durchlauf oder den vorhergehenden Durchläufen durch die Anlage 1 an den Haltemitteln abgesetzt haben.

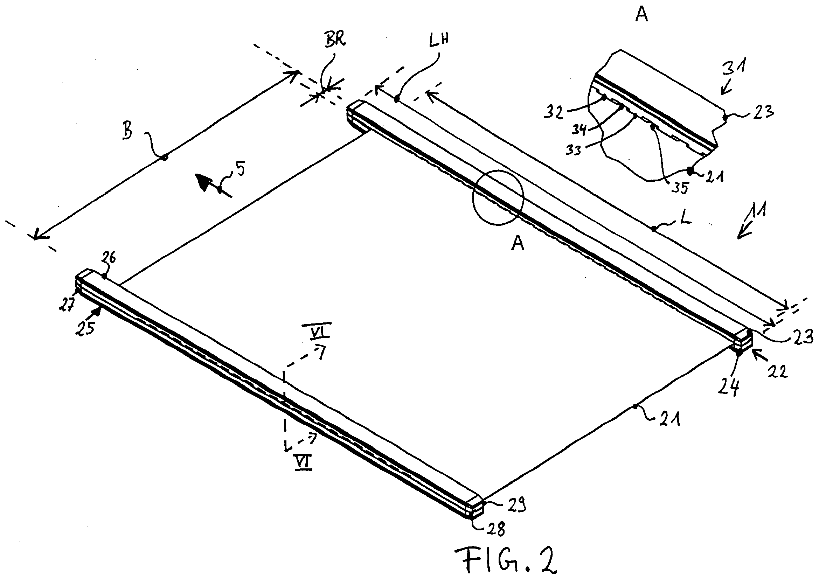

Ausführungsbeispiele für Haltemittel und eine Transportvorrichtung, die zum Transportieren des Behandlungsgutes bei einer Anlage, wie sie schematisch in Fig. 1 dargestellt ist, verwendet werden können, werden unter Bezugnahme auf Fig. 2-8 ausführlicher beschrieben.

Fig. 2 ist eine Perspektivansicht eines von Haltemitteln gehaltenen Behandlungsgutes. Das Behandlungsgut 21 ist als dünne Platte oder Folie mit einer im Wesentlichen rechteckigen Form dargestellt. An den beiden Längsrändern des Behandlungsgutes 21, d.h. an den beiden Rändern, die beim Transportieren des Behandlungsgutes entlang der Transportrichtung gerichtet sind, halten Haltemittel 22 und weitere Haltemittel 25 das Behandlungsgut jeweils an mindestens zwei Punkten der Randabschnitte des Behandlungsgutes 21. Bei dem dargestellten Ausführungsbeispiel halten die Haltemittel 22 und die weiteren Haltemittel 25 den entsprechenden Randbereich jeweils in der Umgebung der Ecken des Behandlungsgutes sowie an einer Mehrzahl von dazwischen angeordneten Punkten.

Die Haltemittel 22 und weiteren Haltemittel 25 sind so ausgestaltet, dass sie das Behandlungsgut 21 in der Breitenrichtung, d.h. in der Richtung, die beim Transportieren des Behandlungsgutes 21 rechtwinklig zu der Transportrichtung in der Transportebene verläuft, über eine maximale Distanz BR übergreifen, die klein im Vergleich zu einer Breite B des Behandlungsgutes 21 ist. Die Haltemittel können eine Breite von ca. 5-45 mm, insbesondere von ca. 10-35 mm, insbesondere von ca. 15-30 mm aufweisen und entsprechend das Behandlungsgut über eine Breite BR übergreifen, die kleiner als die Breite der Haltemittel ist.

Die Haltemittel 22 und die weiteren Haltemittel 25 können so ausgestaltet sein, dass ihre Länge LH der Länge L des Behandlungsgutes 21 entspricht oder größer als die Länge L des Behandlungsgutes 21 ist. Die Haltemittel 22 und weiteren Haltemittel 25 können entsprechend das Behandlungsgut 21 in der Umgebung der Ecken des Behandlungsgutes halten. Wie in Fig. 2 dargestellt, können die Haltemittel 22 und die weiteren Haltemittel 25 so ausgebildet sein, dass sie in dem Zustand, in dem sie das Behandlungsgut 21 halten, in der Längsrichtung an einer oder beiden Seiten des Behandlungsgutes 21 über das Behandlungsgut 21 herausragen. Bei dem in Fig. 2 dargestellten Ausführungsbeispiel ist dazu die Länge LH der Haltemittel 22 und weiteren Haltemittel 25 so gewählt, dass sie größer als die Länge L des Behandlungsgutes 21 ist. Die in Längsrichtung über das Behandlungsgut 21 hinausragenden Abschnitte der Haltemittel 22 und weiteren Haltemittel 25 können dazu dienen, einen Minimalabstand zwischen Behandlungsgütern in der Anlage einzustellen. Die Haltemittel 22 und die weiteren Haltemittel 25 können so an dem Behandlungsgut 21 angebracht werden, dass sie an ihrem in der Transportrichtung 5 vorderen Ende weiter von dem Behandlungsgut 21 abstehen als an ihrem in der Transportrichtung 5 hinteren Ende.

Die Haltemittel 22 und die weiteren Haltemittel 25 sind bei dem in Fig. 2 dargestellten Ausführungsbeispiel schienenförmig ausgebildet und weisen ein Länge LH auf, die groß im Vergleich zu den Abmessungen der Haltemittel 22 bzw. der weiteren Haltemittel 25 in den dazu senkrechten Richtungen ist. Auch wenn in Fig. 2 die Haltemittel 22 und die weiteren Haltemittel 25 als durchgängige Schienen dargestellt sind, können die Haltemittel auch mehrere voneinander in Längsrichtung des Behandlungsgutes beabstandete Abschnitte aufweisen, die miteinander verbunden sind, um das Behandlungsgut 21 an mehreren Punkten in dem Randbereich zu halten. Die mehreren Abschnitte können mit federelastischen Elementen miteinander verbunden sein, die so ausgebildet sind, dass die Abschnitte in Längsrichtung voneinander weg vorgespannt sind, d.h. dass auf die Abschnitte der Haltemittel voneinander weg gerichtete Kräfte in der Längsrichtung ausgeübt werden. Mit den Haltemitteln kann das Behandlungsgut auch in Längsrichtung des Behandlungsgutes gespannt werden.

Die Haltemittel 22 weisen ein schienenförmiges erstes Halteteil 23 und ein schienenförmiges zweites Halteteil 24 auf. Ähnlich weisen die weiteren Haltemittel 25 ein schienenförmiges erstes Halteteil 26 und ein schienenförmiges zweites Halteteil 27 auf. Das erste Halteteil 23, 26 und das zweite Halteteil 24, 27 sind bei dem in Fig. 2 dargestellten Schließzustand der Haltemittel 22 bzw. 25 derart an gegenüberliegenden Seiten des Behandlungsgutes 21 angeordnet, dass der Randbereich des Behandlungsgutes 21 zwischen das erste Halteteil 23, 26 und das zweite Halteteil 24, 27 hineinragt und dort gehalten wird.

Nachfolgend wird die Einzelheit A, die in Fig. 2 bei 31 dargestellt ist, beschrieben. Bei 31 ist der mit A bezeichnete Ausschnitt des gehalterten Behandlungsgutes 21 in einer Detailansicht vergrößert dargestellt. Das obere Halteteil 23 weist eine Kontaktkante mit mehreren Abschnitten 32, 33 auf, die in Richtung des Behandlungsgutes 21 hervorragen. Die dem Behandlungsgut 21 zugewandten Endflächen der Abschnitte 32, 33 der Kontaktkante berühren das Behandlungsgut 21 und halten dieses kraftschlüssig. Zwischen den Abschnitten 32, 33 der Haltekante sind Ausnehmungen 34, 35 vorgesehen. Die Ausnehmungen 34, 35 bilden Flüssigkeitsdurchlässe, die ein Abführen von Behandlungsflüssigkeit durch die Haltemittel 22 erlauben. Die weiteren Haltemittel 25 weisen eine entsprechende Ausgestaltung auf, die spiegelsymmetrisch zu der der Haltemittel 22 ist.

Bei einer weiteren Ausgestaltung können die Haltemittel 22 und die weiteren Haltemittel 25 identisch ausgestaltet sein. Jede von den Haltemitteln 22 und den weiteren Haltemitteln 25 können so ausgebildet sein, dass das obere und untere Halteteil relativ zur Transportebene zueinander spiegelsymmetrisch sind. Das obere und untere Halteteil können beispielsweise mit einem Scharnier verbunden sein.

Die Enden der Haltemittel 22 und der weiteren Haltemittel 25 weisen abgeschrägte Oberflächen 28, 29 auf. Die abgeschrägten Oberflächen 28, 29 sind bei einem Ausführungsbeispiel wenigstens an dem Ende der Haltemittel 22 ausgebildet, das beim Transportieren des Behandlungsgutes zuerst mit der Transportvorrichtung der Anlage gekoppelt wird. Die abgeschrägten Oberflächen 28, 29 können dabei so zueinander angeordnet sein, dass die Haltemittel 22 in Richtung ihrer Enden schmaler werden, um ein Einführen der Haltemittel 22 in die Transportvorrichtung der Behandlungsanlage zu erleichtern.

Die Haltemittel 22 und die weiteren Haltemittel 25 können mit einer geeignet ausgebildeten Transportvorrichtung einer Behandlungsanlage gekoppelt werden, um das von den Haltemitteln 22 und weiteren Haltemitteln 25 gehaltene Behandlungsgut 21 zu transportieren. Dabei erfolgt die Kopplung der Transportvorrichtung mit den Haltemitteln vorteilhaft derart, dass der zentrale Bereich des Behandlungsgutes 21, der als Nutzbereich des Behandlungsgutes einer Behandlung unterzogen wird, nicht in Kontakt mit Elementen der Transportvorrichtung und vorteilhaft auch nicht in Kontakt mit anderen festen Elementen der Prozesslinie kommt, bis die Haltemittel 22 und die weiteren Haltemittel wieder von dem Behandlungsgut 21 gelöst werden.

Fig. 3 ist eine Perspektivansicht einer Transportvorrichtung 41 nach einem Ausführungsbeispiel, die zum Transportieren des mit Haltemitteln gehalterten Behandlungsgutes eingesetzt werden kann. Die Transportvorrichtung 41 kann als Transportvorrichtung in der Prozesslinie 2 der Anlage 1 von Fig. 1 verwendet werden.

Die Transportvorrichtung 41 weist zwei Rollenbahnen 42, 43 auf, die zueinander beabstandet an den Seiten des Transportweges des Behandlungsgutes angeordnet sind. Jede der Rollenbahnen 42, 43 umfasst eine Mehrzahl von entlang der Transportrichtung angeordneten Rollenpaaren. Jedes der Rollenpaare umfasst zwei senkrecht zur Transportebene beabstandete Rollen. Bei der in Fig. 3 dargestellten Transportvorrichtung 41 sind die Rollen 44', 45' vertikal beabstandet angeordnet, so dass eine Rolle 44' oberhalb und eine weitere Rolle 45' unterhalb der horizontalen Transportebene angeordnet ist, in der das Behandlungsgut 21 transportiert wird.

Bei der Transportvorrichtung 41 sind jeweils eine oberhalb der Transportebene angeordnete Rolle 44' der Rollenbahn 43 und eine an der entsprechenden Position der anderen Rollenbahn 42 angeordnete Rolle 44 mit einer Welle verbunden. Entsprechend sind die unterhalb der Transportebene angeordneten Rollen mit einer Welle verbunden. Die Wellen, mit denen die Rollen 44, 44', 45' drehend antreibbar sind, sind an Lagereinsätzen 47 der Transportvorrichtung 41 gelagert. Wenigstens eine der Wellen ist relativ zu der anderen Welle verschiebbar gelagert, beispielsweise in einer sich vertikal erstreckenden Ausnehmung 48 in dem Lagereinsatz 47. Da bei einer solchen Lagerung der vertikale Abstand der Rollen eines Rollenpaares variierbar ist, können beispielsweise Behandlungsgüter mit unterschiedlichen Dicken transportiert werden. An einer Seite der Transportvorrichtung, bei der Transportvorrichtung 41 an der Seite der Rollenbahn 42, sind die Wellen drehfest mit einem Paar von Zahnrädern 46 verbunden, die mit einer (nicht dargestellten) Antriebseinheit über eine (nicht dargestellte) Antriebswelle wirkverbunden sind.

Die Transportvorrichtung 41 transportiert das von den Haltemitteln gehaltene Behandlungsgut 21 in der Transportrichtung, wobei die Transportvorrichtung 41 die Haltemittel 22, 25 berührt, während der zu behandelnde zentrale Nutzbereich des Behandlungsgutes 21 nicht von festen Elementen der Transportvorrichtung berührt wird. Der zentrale Bereich der Behandlungsgutes 21, der einer Behandlung unterzogen wird, kommt in den Behandlungsstationen der Behandlungsanlage mit Flüssigkeiten oder Gasen in Kontakt.

Die Transportvorrichtung 41 ist so ausgebildet, dass sie auf die Haltemittel 22, 25, die an dem Längsrand des Behandlungsgutes 21 das Behandlungsgut halten, jeweils eine Kraft mit einer Kraftkomponente 6, 7 auf die Haltemittel 22, 25 ausüben, die in der Transportebene und quer zu der Transportrichtung gerichtet ist. Dabei übt die Transportvorrichtung 41 auf die Haltemittel 22, 25 Kräfte mit den Kraftkomponenten 6, 7 mit entgegengesetzter Richtung aus, um so das Behandlungsgut 21 in der Richtung quer zu der Transportrichtung zu spannen.

Um einen synchronen Transport der Haltemittel 22, 25 auf beiden Seiten des Behandlungsgutes 21 zu gewährleisten, kann die Transportvorrichtung 41 mit einer (nicht dargestellten) Synchronisationseinrichtung versehen sein. Die Synchronisationseinrichtung kann eingerichtet sein, um einen synchronen Vorschub der auf unterschiedlichen Seiten des Behandlungsgutes 21 angebrachten Haltemittel 22, 25 sicherzustellen. Die Synchronisationseinrichtung kann so realisiert werden, dass eine Bewegung der Haltemittel in der Transportrichtung mit einem Anschlag behindert und die Haltemittel zu einer gewünschten Zeit wieder freigegeben werden können. Die Synchronisationseinrichtung kann dazu wenigstens ein bewegliches Element und einen damit verbundenen Antriebsmechanismus umfassen, mit dem das wenigstens eine bewegliche Element zwischen einer ersten Position, in der das wenigstens eine bewegliche Element mit einem oder beiden der Haltemittel 22, 25 in Eingriff ist, um einen Vorschub des entsprechenden Haltemittels in der Transportrichtung zu verhindern, und einer zweiten Position, in der das bewegliche Element so positioniert wird, dass es den Vorschub des entsprechenden Haltemittels erlaubt, bewegt werden kann. Es kann ein erstes bewegliches Element, beispielsweise ein erster steuerbarer Anschlag, vorgesehen sein, um den Vorschub der Haltemittel 22 an der ersten Seite zu kontrollieren, und es kann ein zweites bewegliches Element, beispielsweise ein zweiter steuerbarer Anschlag, vorgesehen sein, um den Vorschub der Haltemittel 25 an der zweiten Seite zu kontrollieren. Andere Ausgestaltungen der Synchronisationseinrichtung sind möglich. Beispielsweise kann die Synchronisationseinrichtung Zahnräder aufweisen, die beim Transport in die Haltemittel 22, 25 eingreifen, um einen synchronen und wohldefinierten Vorschub der an unterschiedlichen Seiten angebrachten Haltemittel zu verwirklichen.

Wie unter Bezugnahme auf Fig. 4 nachfolgend näher erläutert wird, ist jeweils mindestens eine der Rollen jedes Rollenpaares, beispielsweise die unterhalb der Transportebene vorgesehene Rolle 45, in mindestens einer der Rollenbahnen 42, 43 als Loslager ausgebildet. Das Loslager ist zum Führen der entsprechenden Haltemittel 22 bzw. 25 ausgebildet. Das Loslager übt auf die zugeordneten Haltemittel 22 oder 25 eine Kraft mit einer Kraftkomponente 6, 7 quer zu der Transportrichtung aus, die über die Haltemittel 22 oder 25 auf den entsprechenden Randbereich des Behandlungsgutes übertragen wird.

Fig. 4 zeigt eine Draufsicht auf ein Rollenpaar der Rollenbahn 42 aus der in Fig. 3 mit IV-IV bezeichneten Richtung. Die Transportrichtung ist dabei in die Zeichenebene hinein gerichtet, und die Transportebene schneidet die Zeichenebene in waagrechter Richtung. Elemente, die bereits unter Bezugnahme auf Fig. 3 erläutert wurden, sind mit denselben Bezugszeichen versehen.

Auch wenn unter Bezugnahme auf Fig. 4 ein Rollenpaar der Rollenbahn 42 erläutert wird, können die Rollenpaare der Rollenbahn 43 eine in funktioneller Hinsicht identische Ausgestaltung aufweisen und spiegelsymmetrisch zu der in Fig. 4 dargestellten Konfiguration ausgebildet sein. Insbesondere kann sowohl in der Rollebahn 43 als auch in der Rollenbahn 42 Loslager vorgesehen sein, so dass das Behandlungsgut schwimmend gelagert ist. Bei einem abgewandelten Ausführungsbeispiel der Transportvorrichtung 41 ist nur in einer der Rollenbahnen 42, 43 eine Rolle als Loslager ausgestaltet, während die andere Rollenbahn die zugeordneten Haltemittel an einer vorgegebenen Position führt und als Festlager wirkt.

Das Rollenpaar umfasst die Rollen 44, 45, die so angeordnet sind, dass die Haltemittel 22, die das Behandlungsgut 21 halten, zwischen ihnen transportiert werden können. Die Rolle 44 ist an einer Welle 51 angebracht. Die Rolle 45 ist an einer weiteren Welle 52 angebracht. Die Welle 51 ist drehfest mit einem Zahnrad 46a gekoppelt, und die weitere Welle 52 ist drehfest mit einem Zahnrad 46b gekoppelt. Die Zahnräder 46a und 46b befinden sich in Eingriff, so dass bei Drehung des Zahnrades 46b auch das Zahnrad 46a drehend angetrieben wird. Das Zahnrad 46b ist mit einem Kegelrad 46c gekoppelt, das mit einer (nicht dargestellten) Antriebswelle wirkverbunden ist.

Die Rolle 45 weist eine Führungsnut 53 für die Haltemittel 22 auf. Die Rolle 45 ist so an der Welle 52 angebracht, dass sie entlang der Welle 52 über einen gewissen Bereich axial verschiebbar ist. Auf diese Weise bildet die Rolle 45 ein Loslager für die Haltemittel 22 aus, an dem die Haltemittel 22 so gelagert werden, dass sie durch Drehung der Rollen 44, 45 in der Transportrichtung bewegt werden. Durch die axial bewegliche Lagerung der Rolle 45 entlang der Welle 52 kann auf die Haltemittel 22 und somit auf den von den Haltemitteln 22 gehaltenen Randbereich der Folie eine Kraft mit einer Kraftkomponente in der Transportebene quer zur Transportrichtung ausgeübt werden. Die Rolle 44 weist eine zylinderförmige Mantelfläche auf. Die Mantelfläche der Rolle 44 ist so ausgestaltet, dass die Rolle 44 die Haltemittel 22 unabhängig von der Position der Rolle 45 mit der Führungsnut 53 an der der Führungsnut entgegengesetzten Seite (in Fig. 4 oben) der Haltemittel 22 berühren kann. Die Transportvorrichtung kann vorteilhaft so ausgebildet sein, dass der zwischen der Rolle 45 und den Haltemitteln 22 wirkende Reibschluss einen schlupffreien Transport der Haltemittel 22 gewährleisten kann. Wie nachfolgend noch näher beschrieben werden wird, können dazu Gewichte vorgesehen sein, um die Kraft zu erhöhen, mit der die Rolle 44 die Haltemittel 22 in die Führungsnut 53 und gegen die Rolle 45 drückt.

Die Transportvorrichtung umfasst Kraftmittel, die auf die Rolle 45 eine Kraft parallel zu der Welle 52 ausüben. Die Kraftmittel umfassen bei der in Fig. 4 dargestellten Ausgestaltung einen Magneten 54, der an der Rolle 45 angebracht ist, und einen weiteren Magneten 55, der von einer Halterung 56 an einer festen Axialposition entlang der Welle 52 gehalten wird. Die Magnete 54, 55 können als Permanentmagnete ausgebildet sein. Der an der Rolle 45 angebrachte Magnet 54 und der weitere Magnet 55 sind so ausgerichtet, dass eine abstoßende Kraft zwischen ihnen wirkt. Die abstoßende Kraft zwischen den Magneten 54, 55 führt dazu, dass auf die Rolle 45 in axialer Richtung entlang der Welle 52 eine Kraft 57 wirkt. Wenn die Haltemittel 22 in die Führungsnut 53 einfahren, kann die Rolle 45 eine Bewegung in axialer Richtung entlang der Welle 52 ausführen und übt über den Rand der Führungsnut 53 die Kraft 57 quer zur Transportrichtung auf die Haltemittel 22 aus. Auf diese Weise kann das Behandlungsgut 21 von der Transportvorrichtung 41 federnd gespannt werden.

Um den Transport von Behandlungsgut 21 mit unterschiedlicher Dicke bzw. die Verwendung von unterschiedlich ausgestalteten Haltemitteln zu ermöglichen, ist die Welle 51 an dem Lagereinsatz 47 relativ zu der Welle 52 beweglich gelagert. Beispielsweise kann sich die Welle 51 relativ zu der Welle 52 in vertikaler Richtung bewegen. Ein Drehmitnehmer 62 ist an der Welle 52 angebracht. Zwischen dem Drehmitnehmer 62 und der Rolle 45 ist eine Kupplung 64 zur Übertragung eines Drehmoments von der Welle 52 auf die Rolle 45 vorgesehen. Die Kupplung 64 ist so ausgestaltet, dass die axiale Bewegung der Rolle 45 entlang der Welle 62 möglich ist, während die Kupplung 64 zur Übertragung des Drehmomentes eingerückt bleibt. Ein Anschlagelement 61 ist an der Welle 51 angebracht, das in Anlage mit dem Drehmitnehmer 62 kommen kann, um die Bewegung der Wellen 51, 52 aufeinander zu zu begrenzen. Das Anschlagelement 61 und der Drehmitnehmer 62 sind so ausgestaltet, dass die Haltemittel 22 mit ihrem abgefasten Ende sicher in den Zwischenraum zwischen der Führungsnut 53 der Rolle 45 und der Rolle 44 einfahren können, wenn das Anschlagelement 61 und der Drehmitnehmer 62 aneinander anliegen. An der Welle 51 sind Gewichte 63 angebracht, um die Kraft zu erhöhen, mit der die Rolle 44 die Haltemittel 22 in die Führungsnut 53 und gegen die Rolle 45 drückt. Auf diese Weise kann der Reibschluss zwischen den Rollen 44, 45 und den Haltemitteln 22 verbessert werden, und die Haltemittel 22 können in der Führungsnut 53 der Rolle 45 gesichert werden

Abwandlungen der unter Bezugnahme auf Fig. 4 erläuterten Ausbildung des Rollenpaares der Transportvorrichtung können bei weiteren Ausführungsbeispielen realisiert werden. Beispielsweise können anstelle der Führungsnut 53 der Rolle 45, in die die Außenfläche der Haltemittel 22 eingreift, an einer Rolle der Transportvorrichtung und an den Haltemitteln andere komplementäre Eingriffsabschnitte vorgesehen sein, mit denen eine auf die Rolle 45 entlang der Welle 52 wirkende Axialkraft auf die Haltemittel 22 übertragen wird.

Die auf die Haltemittel 22 in Breitenrichtung des Behandlungsgutes 21 wirkende Kraft muss nicht über die Rolle 45 auf die Haltemittel 22 ausgeübt werden. Bei einem weiteren Ausführungsbeispiel kann der Magnet 54 beispielsweise nicht an der Rolle 45 selbst, sondern an einem davon separaten Element angeordnet sein, das eingerichtet ist, um eine Kraft mit einer Komponente in Breitenrichtung des Behandlungsgutes auf die Haltemittel 22 auszuüben.

Bei einem weiteren Ausführungsbeispiel kann eine magnetische Kraft nicht indirekt über ein Loslager, sondern von einem an der Welle 52 montierten Magneten, wie dem Permanentmagneten 55, unmittelbar auf die Haltemittel 22 ausgeübt werden. In den Haltemitteln 22 können Permanentmagnete vorgesehen sein, die mit dem an der Welle 52 montierten Magneten wechselwirken. Der an der Welle 52 montierte Magnet und die Permanentmagnete der Haltemittel 22 können so ausgebildet und angeordnet sein, dass auf die Haltemittel 22 eine Kraft mit einer Komponente ausgeübt wird, die so gerichtet ist, dass das Behandlungsgut in der Breitenrichtung gespannt wird. Die Rolle 45 kann mit einer zylinderförmigen Mantelfläche ausgebildet sein, entlang der sich die Haltemittel 22 in der Breitenrichtung des Behandlungsgutes 21 unter Einwirkung der Kraft bewegen können, die von dem an der Welle 52 montierten Magneten auf die Haltemittel 22 ausgeübt wird.

Anstelle der Magnete 54, 55 können andere geeignete Mittel verwendet werden, um auf die Haltemittel 22 eine Kraft mit einer Komponente in der Transportebene und quer zu der Transportrichtung auszuüben, die das Behandlungsgut federnd spannt. Beispielsweise kann eine federelastisches Element verwendet werden, um auf die Rolle 45 eine Kraft entlang der Welle 52 auszuüben.

Bei einem weiteren Ausführungsbeispiel können die Haltemittel 22 quer zu ihrer Längsrichtung, d.h. in der Breitenrichtung des Behandlungsgutes, mit einem Fluidstrom angeströmt werden, um auf die Haltemittel 22 eine Kraft auszuüben, die so gerichtet ist, dass das Behandlungsgut 21 in der Breitenrichtung gespannt wird.

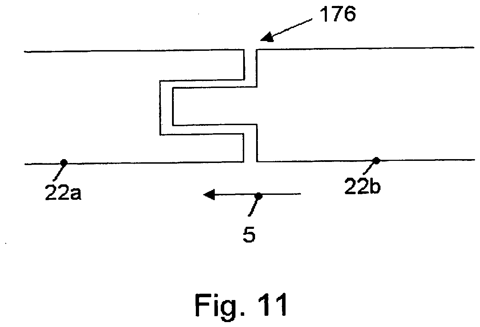

Fig. 11 zeigt ein eine Kopplung 176 zwischen benachbarten Haltemitteln 22a und 22b, mit der nach einer Ausführungsform bei den verschiedenen hier beschriebenen Verfahren und Vorrichtungen eine Verschränkung zwischen den benachbarten Haltemitteln 22a und 22b erreicht werden kann. Die Endabschnitte der Haltemittel sind so ausgestaltet, dass Kräfte von einem Haltemittel 22a auf ein benachbartes Haltemittel 22b übertragen werden. Die Verschränkung kann beispielsweise über eine mechanische Kopplung, beispielsweise eine Nut-Feder-Anordnung realisiert sein, wie in Fig. 11 gezeigt. Indem vorlaufende Haltemittel 22a und nachlaufende Haltemittel 22b miteinander verschränkt werden, können Kraftspitzen auf die Vorder- oder Hinterkante des Behandlungsgutes 21 (in Transportrichtung gesehen) reduziert, vorteilhaft vollständig unterdrückt, werden. Durch die Verschränkung 176 werden Kräfte, die auf ein Haltemittel wirken, auch von einem benachbarten Haltemittel aufgenommen. Insbesondere kann eine Verschränkung derart realisiert werden, dass durch die Verschränkung Kräfte quer zu der Transportrichtung 5 von einem Halteelement 22a zu dem benachbarten Halteelement 22b übertragen werden. Die Verschränkung 176 kann durch eine geeignete geometrische Ausgestaltung der Haltemittel 22a, 22b, beispielsweise mit einer Passung mit geringem Spiel von kleiner 1 mm oder auch kraftschlüssig erfolgen. Auch eine formschlüssige Verbindung in der Art miteinander verbundener Kettenglieder ist möglich, um die Verschränkung herzustellen.

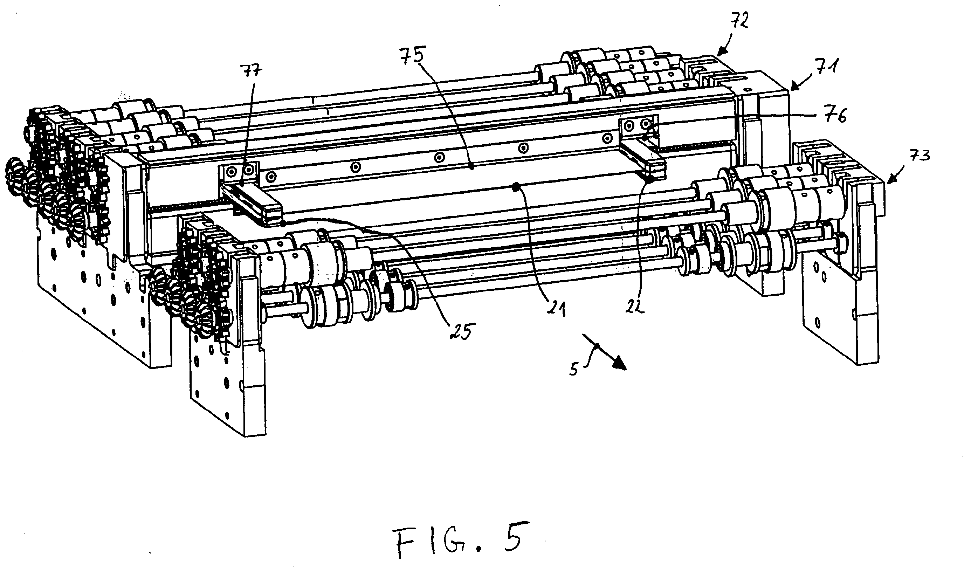

Fig. 5 ist eine Perspektivansicht, die einen Abschnitt einer Behandlungsanlage zeigt, in dem das Behandlungsgut 21 in einer Behandlungsstation 71 behandelt wird. Das mit den Haltemitteln 22, 25 gehalterte Behandlungsgut 21 wird der Behandlungsstation 71 durch einen Abschnitt 72 der Transportvorrichtung der Behandlungsanlage zugeführt und wird von der Behandlungsstation 71 durch einen weiteren Abschnitt 73 der Transportvorrichtung der Behandlungsanlage weitertransportiert. Die Abschnitte 72, 73 der Transportvorrichtung können wie die unter Bezugnahme auf Fig. 3 und 4 beschriebene Transportvorrichtung 41 ausgebildet sein. Die Abschnitte 72, 73 der Transportvorrichtung können so angeordnet sein, dass die Haltemittel 22, 25 für jede Position des gehalterten Behandlungsgutes 21 mit wenigstens einem der Abschnitte 72, 73 derart gekoppelt sind, dass das Behandlungsgut 21 sicher weitertransportiert und gegebenenfalls quer zur Transportrichtung gespannt wird.

Bei der Behandlungsstation kann es sich beispielsweise um eine Station zur chemischen Behandlung des Behandlungsgutes 21, einer Station zum Spülen des Behandlungsgutes 21 oder einer Station zum Trocknen des Behandlungsgutes 21 oder zum Abblasen von Flüssigkeit von dem Behandlungsgut 21 handeln. Entsprechend kann eine Düsenanordnung der Behandlungsstation 71 dem Behandlungsgut 21 eine Prozesschemikalie, Wasser oder ein Gas zuführen, beispielsweise durch Anströmen.

Die Behandlungsstation weist einen Zuführbereich 75 auf, mit dem dem zentralen Nutzbereich des Behandlungsgutes 21, der von den Haltemitteln 22, 25 nicht überdeckt wird, das entsprechende Behandlungsfluid, beispielsweise eine Prozesschemikalie, Wasser oder ein Gas, zugeführt wird. Der Zuführbereich 75 kann beispielsweise eine Düsenanordnung zum Anströmen des Nutzbereichs mit dem Behandlungsfluid aufweisen. Der Zuführbereich 75 ist so angeordnet, dass er bis in die Nähe des zentralen Nutzbereiches des Behandlungsgutes reicht, dieses aber nicht berührt. Insbesondere kann der Zuführbereich 75 so angeordnet sein, dass ein dem Behandlungsgut 21 zugewandter Abschnitt desselben zwischen die Haltemittel 22, 25 hineinragt.

An der zu dem Zuführbereich 75 entgegengesetzten Seite des Behandlungsgutes 21 (in Fig. 5 unterhalb der Transportebene) kann ein weiterer Zuführbereich vorgesehen sein, um .der entgegengesetzten Seite des Behandlungsgutes das Behandlungsfluid zuzuführen, beispielsweise durch Anströmen. Die an den entgegengesetzten Seiten des Behandlungsgutes 21 vorgesehenen Zuführbereiche können so ausgebildet sein, dass von oben und unten in symmetrischer Weise auf das Behandlungsgut eingewirkt wird, um eine Auslenkung des Behandlungsgutes 21 aus der Transportebene gering zu halten. Die an den entgegengesetzten Seiten des Behandlungsgutes 21 vorgesehenen Zuführbereiche können so ausgebildet sein und die auf das Behandlungsgut in Breitenrichtung ausgeübte Kraftkomponente kann so gewählt sein, dass die Oberseite des Behandlungsgutes einen über die Breite des Behandlungsgutes im Wesentlichen konstanten Abstand von dem Zuführbereich 75 aufweist, und dass die Unterseite des Behandlungsgutes einen über die Breite des Behandlungsgutes im Wesentlichen konstanten Abstand von einem entsprechenden Zuführbereich der Behandlungsstation 71 für die Unterseite des Behandlungsgutes aufweist. Die an den entgegengesetzten Seiten des Behandlungsgutes 21 vorgesehenen Zuführbereiche können so ausgebildet sein und die auf das Behandlungsgut in Breitenrichtung ausgeübte Kraftkomponente kann so gewählt sein, dass diese Abstände gleich sind.

An beiden Seiten des Zuführbereiches 75 sind Ausnehmungen vorgesehen, durch die die Haltemittel 22, 25 transportiert werden, wenn das Behandlungsgut 21 durch die Behandlungsstation 71 transportiert wird. Optional können weitere Zuführbereiche 76, 77 seitlich des Zuführbereichs 75 vorgesehen sein, mit denen das Behandlungsfluid auch den Haltemitteln 22, 25 zugeführt wird, beispielsweise durch Anströmen mit dem Behandlungsfluid. Die weiteren Zuführbereiche 76, 77 können abhängig davon vorgesehen werden, ob die Haltemittel 22, 25 ebenfalls der Behandlung in der jeweiligen Behandlungsstation unterzogen werden sollen. Beispielsweise können die weiteren Zuführbereiche 76, 77 in Behandlungsstationen vorgesehen sein, in denen das Behandlungsgut mit Wasser gespült oder mit einem Gasstrom getrocknet wird. Die Behandlungsstation kann hingegen so ausgebildet sein, dass keine Zuführbereiche 76, 77 für die Haltemittel vorgesehen sind, wenn mit der Behandlungsstation dem Behandlungsgut bzw. dem von den Haltemitteln nicht überdeckten Nutzbereich des Behandlungsgutes 21 eine Prozesschemikalie zugeführt wird. In Behandlungsstationen, in denen Prozesschemikalien zugeführt wird, kann so vermieden werden, dass die Haltemittel 22, 25 direkt mit Prozesschemikalien besprüht werden, was zu einem verstärkten Auftreten unerwünschter Ablagerungen führen könnte.

Falls, wie oben beschrieben, die Haltemittel 22, 25 zusammen mit dem Behandlungsgut gespült und getrocknet werden, können in den Spül- und Trockenstationen Spuren einer Prozesschemikalie von den Haltemitteln 22, 25 entfernt werden, die in einer vorhergehenden Behandlung des Nutzbereichs des Behandlungsgutes mit der Prozesschemikalie auf die Haltemittel 22, 25 gelangt sind.

Die Behandlungsstation kann auch so ausgebildet sein, dass in Bereichen, in denen die Haltemittel 22, 25 durch die Behandlungsstation geführt werden, eine selektive Behandlung der Haltemittel 22, 25 erfolgt, während der Nutzbereich des Behandlungsgutes in der Behandlungsstation keiner direkten Behandlung unterzogen wird. Auf diese Weise können beispielsweise an den Haltemitteln 22, 25 verbliebene Prozesschemikalien entfernt werden, um ein Verschleppen zu vermeiden. Zum Entfernen von Flüssigkeit von der Oberfläche des Behandlungsgutes 21 können auch schwimmend gelagerte, insbesondere in Axialrichtung verschiebbar gelagerte Walzen, verwendet werden.

Während unter Bezugnahme auf Fig. 5 der Transport des mit den Haltemitteln gehalterten Behandlungsgutes durch eine Behandlungsstation beschrieben wurde, in der ein Behandlungsfluid zugeführt wird, können Behandlungsstationen mit einer entsprechenden Ausgestaltung auch für andere Behandlungsschritte ausgebildet sein. Beispielsweise kann die Behandlungsstation ausgebildet sein, um dem Behandlungsgut eines oder mehrere von einem Behandlungsfluid, elektrischem Strom, Energie, Impuls oder Strahlung zuzuführen. Die Behandlungsstation kann so ausgebildet sein, dass der zu behandelnde Nutzbereich des Behandlungsgutes, der nicht von den Haltemitteln 22, 25 überdeckt ist, nicht mit festen Teilen der Behandlungsstation oder Transportvorrichtung in Berührung kommt.

Wie aus der unter Bezugnahme auf Fig. 5 erläuterten Ausgestaltung der Behandlungsstation 71 ersichtlich ist, erlaubt es die Anordnung der Haltemittel 22, 25 an den Randbereichen des Behandlungsgutes 21, die parallel zu der Transportrichtung verlaufen, dass der Zuführbereich 75 für das Behandlungsfluid der Behandlungsstation 71 so ausgestaltet werden kann, dass er nahe an den von den Transportmitteln 22, 25 nicht überdeckten Nutzbereich des Behandlungsgutes reichen kann. Insbesondere ist der Abstand des Zuführbereichs 75 vom Behandlungsgut 21 nicht durch die Abmessungen der Haltemittel 22, 25 beschränkt.

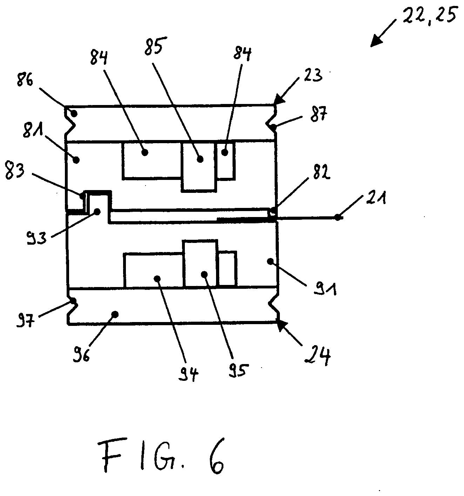

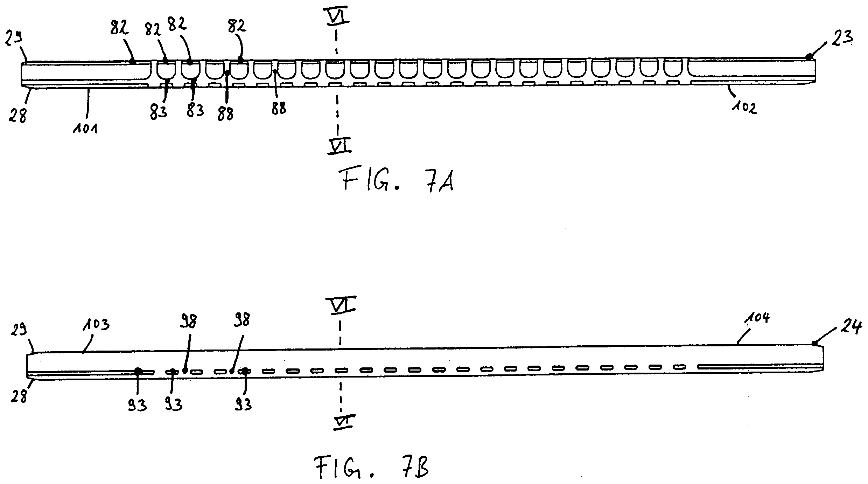

Unter Bezugnahme auf Fig. 6 und 7 werden Haltemittel nach einem Ausführungsbeispiel beschrieben. Die Haltemittel können zum Halten des Behandlungsgutes 21 verwendet werden und sind ausgestaltet, um mit der Transportvorrichtung der unter Bezugnahme auf Fig. 3-5 erläuterten Behandlungsanlage zum Transportieren des Behandlungsgutes 21 zusammenzuwirken.

Fig. 6 zeigt eine Querschnittsansicht durch die Haltemittel 22, 25 an einer Position, die in Fig. 2 und 7 schematisch mit der Linie VI-VI dargestellt ist. Fig. 7A ist eine Draufsicht auf das erste Halteteil 23 der Haltemittel, und Fig. 7B ist eine Draufsicht auf das zweite Halteteil 24 der Haltemittel. Die Draufsicht des ersten Halteteils 23 in Fig. 7A zeigt die Seite des ersten Halteteils 23, die im Schließzustand der Haltemittel dem zweiten Halteteil 24 zugewandt ist. Die Draufsicht des zweiten Halteteils 24 in Fig. 7B zeigt die Seite des zweiten Halteteils 24, die im Schließzustand der Haltemittel dem ersten Halteteil 23 zugewandt ist. Die in Fig. 7A und 7B unten dargestellte Kante des ersten und zweiten Halteteils entspricht der in Fig. 6 links dargestellten, von dem Behandlungsgut abgewandten Seite der Haltemittel.

Die Haltemittel 22 bzw. 25 umfassen die zwei separaten schienenförmigen Halteteile 23, 24, die in dem in Fig. 6 dargestellten Schließzustand der Haltemittel 22 an entgegengesetzten Seiten des Behandlungsgutes 21 angebracht sind und das Behandlungsgut 21 kraftschlüssig dazwischen halten. In einem Offenzustand sind die Halteteile 23, 24 voneinander getrennt, so dass das Behandlungsgut 21 zwischen die Halteteile 23, 24 eingefügt oder aus den Haltemitteln 22 entnommen werden kann.

Das erste Halteteil 23 umfasst einen Körper 81, an dem eine Kontaktkante 82 zum Halten des Behandlungsgutes 21 ausgebildet ist. Der Körper 81 weist eine Nut 83 auf, die zusammen mit einer komplementären Ausgestaltung des zweiten Halteteils 24 als Positionierungsmittel wirkt, um die Halteteile 23, 24 im Schließzustand relativ zueinander zu positionieren.

Der Körper 81 des ersten Halteteils 23 weist einen Versteifungskern 84 aus einem Material mit hoher Steifigkeit, beispielsweise einem Metall, auf. In dem Körper 81 ist ein Magnet 85 angeordnet. Der Magnet 85 kann quaderförmig sein. Der Kern 84 kann aus einem ferromagnetischen Metall ausgebildet sein, um die magnetische Anziehungskraft zwischen den ersten und zweiten Halteteilen zu erhöhen.

Das erste Halteteil 23 umfasst weiterhin einen weiteren Körper 86. Der weitere Körper 86 ist an dem Körper 81 so angebracht, dass der Versteifungskern 84 und der Magnet 85 vollständig von den beiden Körpern 81, 86 umgeben sind. Eine Außenoberfläche des weiteren Körpers 86 weist ein Profil 87 auf. In das Profil 87 können beispielsweise Eingriffsmittel einer Be- oder Entladeeinrichtung eingreifen, um die Haltemittel zwischen dem Schließzustand und dem Offenzustand zu überführen.

Die Körper 81, 86 können aus einem Kunststoff ausgebildet sein, insbesondere aus einem Kunststoff, der gegenüber den in der Behandlungsanlage verwendeten Chemikalien inert ist. In diesem Fall sind der Versteifungskern 84 und der Magnet 85 vollständig mit Kunststoff ummantelt. Bei einem weiteren Ausführungsbeispiel können die Körper 81, 86 integral als ein einziger Kunststoffkörper ausgebildet sein. Die Körper 81, 86 können auch aus einem nichtleitenden Material, beispielsweise aus Keramik, oder aus einem Edelstahl hergestellt sein.

Das zweite Halteteil 24 umfasst einen Körper 91, an dem ein Vorsprung 93 ausgebildet ist. Der Vorsprung 93 ist so ausgebildet, dass er in die Nut 83 des ersten Halteteils 23 einfügbar ist und zusammen mit dieser als Positionierungsmittel wirkt, um die Halteteile 23, 24 im Schließzustand relativ zueinander zu positionieren.

Der Körper 91 des zweiten Halteteils 24 weist einen Versteifungskern 94 aus einem Material mit hoher Steifigkeit, beispielsweise einem Metall, auf. In dem Körper 91 ist ein Magnet 95 angeordnet. Der Kern 94 kann aus einem ferromagnetischen Metall ausgebildet sein, um die magnetische Anziehungskraft zwischen den ersten und zweiten Halteteilen zu erhöhen. Der Magnet 95 ist so angeordnet, dass in dem in Fig. 6 dargestellten Schließzustand der Haltemittel 22 eine attraktive Kraft zwischen den Magneten 85, 95 besteht.

Das zweite Halteteil 24 umfasst weiterhin einen weiteren Körper 96. Der weitere Körper 96 ist an dem Körper 91 so angebracht, dass der Versteifungskern 94 und der Magnet 95 vollständig von den beiden Körpern 91, 96 umgeben sind. Eine Außenoberfläche des weiteren Körpers 96 weist ein Profil 97 auf. In das Profil 97 können beispielsweise Eingriffsmittel einer Be- oder Entladeeinrichtung eingreifen, um die Haltemittel zwischen dem Schließzustand und dem Offenzustand zu überführen.

Die Körper 91, 96 des zweiten Halteteils 24 können aus einem Kunststoff ausgebildet sein, insbesondere aus einem Kunststoff, der gegenüber den in der Behandlungsanlage verwendeten Chemikalien inert ist. In diesem Fall sind der Versteifungskern 94 und der Magnet 95 vollständig mit Kunststoff ummantelt. Bei einem weiteren Ausführungsbeispiel können die Körper 91, 96 integral als ein einziger Kunststoffkörper ausgebildet sein. Die Körper 91, 96 können auch aus einem nichtleitenden Material, beispielsweise aus Keramik, oder aus einem Edelstahl hergestellt sein.

Das erste Halteteil 23 und das zweite Halteteil 24 können mit einem Material beschichtet sein, das so gewählt ist, dass eine Benetzung der Halteteile 23, 24 mit wenigstens einem der in der Anlage zur Behandlung des Behandlungsgutes verwendeten Behandlungsfluiden verringert wird. Insbesondere kann die Beschichtung so gewählt sein, dass eine Verschleppung von Prozesschemikalien verringert oder unterbunden wird.

Wie in den Draufsicht von Fig. 7A ersichtlich, kann das erste Halteteil 23 derart segmentiert sein, dass die in der Querschnittsansicht von Fig. 6 dargestellte Struktur des ersten Halteteils 23 in einem zentralen Bereich des Halteteils 23 von Ausnehmungen 88 unterbrochen ist. Die Ausnehmungen 88 erstrecken sich in einer Richtung durch das erste Halteteil 23, die der Breitenrichtung des Behandlungsgutes 21 entspricht, wenn die Haltemittel 22 das Behandlungsgut 21 halten. Die Ausnehmungen 88 unterbrechen die Kontaktkante 82, so dass die Abschnitte der Kontaktkante 82 das Behandlungsgut an einer Vielzahl separater linienförmiger Abschnitte halten.

Wie in den Draufsicht von Fig. 7B ersichtlich, kann das zweite Halteteil 24 derart segmentiert sein, dass die in der Querschnittsansicht von Fig. 6 dargestellte Struktur des zweiten Halteteils 24 in einem zentralen Bereich des Halteteils 24 von Ausnehmungen 98 unterbrochen ist. Die Ausnehmungen 98 erstrecken sich in einer Richtung durch das zweite Halteteil 24, die der Breitenrichtung des Behandlungsgutes 21 entspricht, wenn die Haltemittel 22 das Behandlungsgut 21 halten. Die Ausnehmungen 98 unterbrechen den Vorsprung 93. Die Ausnehmungen 98 sind an Positionen entlang der Längsrichtung des zweiten Halteteils 24 vorgesehen, die den Positionen der Ausnehmungen 88 an dem ersten Halteteil 23 entsprechen. Im Schließzustand der Haltemittel 22 sind die Ausnehmungen 88 in dem ersten Halteteil 23 somit mit den Ausnehmungen 98 in dem zweiten Halteteil 24 ausgerichtet. Die Ausnehmungen 88, 98 definieren Durchgänge durch die Haltemittel 22, die sich im Schließzustand der Haltemittel 22 quer, d.h. in der Breitenrichtung des Behandlungsgutes 21, durch die Haltemittel 22 erstrecken. Derartige Durchgänge erlauben den Abtransport von Flüssigkeit von dem Behandlungsgut durch die Haltemittel 22. Es kann vorteilhaft sein, dass die Kontaktkante 82 um weniger als 1 mm gegenüber der Ausnehmung 88 hervorsteht. Entsprechend kann, wenn die Haltemittel 22 an dem Behandlungsgut 21 angebracht sind, ein Spalt zwischen der Oberseite des Behandlungsgutes 21 und der Ausnehmung 88 eine Höhe von weniger als 1 mm aufweisen, wobei die Höhe senkrecht zu der Transportebene gemessen wird. Weiterhin kann es vorteilhaft sein, dass der Vorsprung 93 um weniger als 1 mm gegenüber der Ausnehmung 98 hervorsteht. Entsprechend kann, wenn die Haltemittel 22 an dem Behandlungsgut 21 angebracht sind, ein Spalt zwischen der Unterseite des Behandlungsgutes 21 und der Ausnehmung 98 eine Höhe von weniger als 1 mm aufweisen.

Wie ebenfalls in den Draufsichten von Fig. 7A und 7B ersichtlich ist, sind an Endbereichen 101, 102 des ersten Halteteils 23 und an Endbereichen 103, 104 des zweiten Halteteils 24 keine Ausnehmungen 88 oder 98 vorgesehen. In den Endbereichen 101, 102, 103, 104 kann entsprechend eine größere Anzahl von Magneten 85 bzw. 95 pro Länge in dem ersten bzw. zweiten Halteteil 23, 24 vorgesehen werden. Dadurch wird die Haltekraft, mit der die ersten und zweiten Halteteile 23, 24 im Schließzustand der Haltemittel 22 in den Endbereichen zusammengehalten werden, erhöht. Eine derartige Erhöhung der Haltekraft führt zu einer besonders sicheren Halterung der Randbereiche des Behandlungsgutes 21, die zwischen den Endbereichen 101 und 103 bzw. 102 und 104 gehalten werden. Die Halteteile 23, 24 können so ausgebildet sein, dass zwischen den Endbereichen 101 und 103 bzw. 102 und 104 die Ecken des Behandlungsgutes gehalten werden. Ein Freiarbeiten der Ecken des Behandlungsgutes aus den Haltemitteln 22 beim Transportieren des Behandlungsgutes kann so verringert oder verhindert werden.

Bei Haltemitteln nach einem weiteren Ausführungsbeispiel kann sich die in der Querschnittsansicht von Fig. 6 dargestellte Ausbildung kontinuierlich über die Länge des ersten und zweiten Halteteils erstrecken, d.h. die ersten und zweiten Halteteile können auch so ausgebildet sein, dass sie keine Durchlässe für den Durchtritt von Flüssigkeit bilden. In diesem Fall erstreckt sich die Kontaktkante 82 kontinuierlich entlang der Längsrichtung des Behandlungsgutes 21 und hält den Randabschnitt des Behandlungsgutes 21 an einer Vielzahl von Punkten, die auf einer kontinuierlichen Linie angeordnet sind.

Bei Haltemitteln nach einem weiteren Ausführungsbeispiel können die Positionierungsmittel, die die Anordnung des oberen und unteren Halteteils im Schließzustand der Haltemittel bestimmen, auch anders als durch eine Nut-Vorsprung-Anordnung ausgebildet sein. Beispielsweise können das obere Halteteil und das untere Halteteil mit einem Scharnier miteinander verbunden sein. Das obere und das untere Halteteil können dabei eine relativ zur Transportebene zueinander spiegelsymmetrische Ausgestaltung aufweisen. Ein derartiges Halteteil kann zum Haltern des Behandlungsgutes an jedem der zwei Längsränder eingesetzt werden.

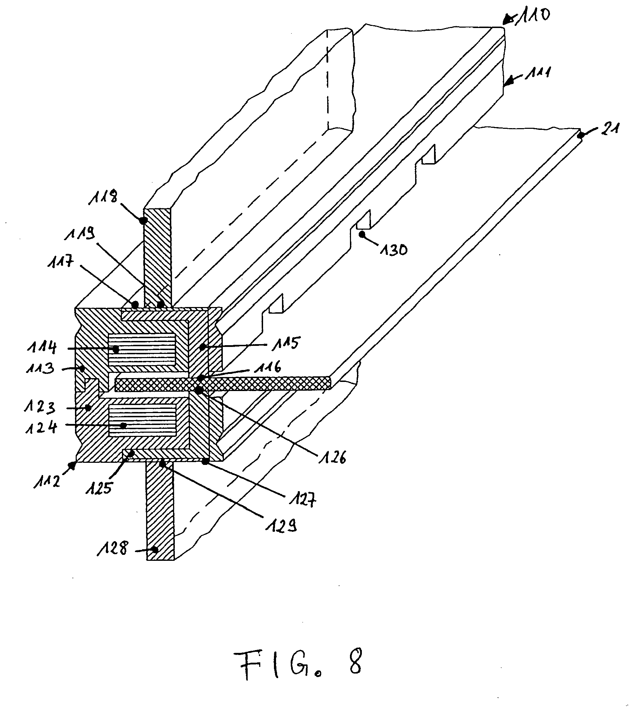

Fig. 8 ist eine Perspektivansicht von Haltemitteln 110 nach einem weiteren Ausführungsbeispiel. Die Haltemittel 110 können zum Halten des Behandlungsgutes 21 verwendet werden. Die Haltemittel 110 sind so eingerichtet, dass sie das Behandlungsgut 21 nicht nur mechanisch halten, sondern auch zur elektrischen Kontaktierung des Behandlungsgutes 21 eingesetzt werden können. Die Haltemittel 110 können zur elektrischen Kontaktierung von Leiterfolien, aber auch von dickeren Platten in einer elektrolytischen Behandlungsanlage bzw. in einem Plater verwendet werden.

Die Haltemittel 110 umfassen zwei separate schienenförmige Halteteile 111, 112, die in dem in Fig. 8 dargestellten Schließzustand der Haltemittel 110 an entgegengesetzten Seiten des Behandlungsgutes 21 angebracht sind und das Behandlungsgut 21 kraftschlüssig dazwischen halten. In einem Offenzustand sind die Halteteile 111, 112 voneinander getrennt, so dass das Behandlungsgut 21 zwischen die Halteteile 111, 112 eingefügt oder aus den Haltemitteln 110 entnommen werden kann.

Das erste Halteteil 111 umfasst einen Körper 113, der aus einem Kunststoff, insbesondere aus einem gegenüber den in der Behandlungsanlage verwendeten Prozesschemikalien inerten Kunststoff ausgebildet sein kann. Der Körper 113 kann auch ein nichtleitendes Material, beispielsweise Keramik, oder Edelstahl umfassen. In den Körper 113 ist ein Magnet 114 eingebettet. Das zweite Halteteil 112 umfasst einen Körper 123, der aus einem Kunststoff, insbesondere aus einem gegenüber den in der Behandlungsanlage verwendeten Prozesschemikalien inerten Kunststoff ausgebildet sein kann. Der Körper 123 kann auch ein nichtleitendes Material, beispielsweise Keramik, oder Edelstahl umfassen. In den Körper 123 ist ein Magnet 124 eingebettet. Die Magnete 114, 124 sind so angeordnet, dass in dem in Fig. 8 dargestellten Schließzustand der Haltemittel 110 eine attraktive Kraft zwischen den Magneten 114, 124 besteht.

Das erste Halteteil 111 weist eine Nut auf, die mit einem korrespondierenden Vorsprung des zweiten Halteteils 112 zusammenwirkt, um die relative Positionierung der Halteteile 111, 112 im Schließzustand der Haltemittel 110 festzulegen. Die Seitenflächen des ersten Halteteils 111 und des zweiten Halteteils 112 sind profiliert, um einen formschlüssigen Eingriff, beispielsweise zum Überführen der Haltemittel von dem Schließzustand in den Offenzustand, zu erlauben. In den Haltemitteln 111 können Durchlässe 130 ausgebildet sein, die sich quer durch die Haltemittel 110 erstrecken, um den Abtransport von Flüssigkeit von dem Behandlungsgut 21 durch die Haltemittel 110 zu ermöglichen. Da diese Ausgestaltungsmerkmale Ausgestaltungsmerkmalen der unter Bezugnahme auf Fig. 6 und 7 beschriebenen Haltemittel 22 entsprechen, wird ergänzend auf die Beschreibung von Fig. 6 und 7 Bezug genommen.

In dem Körper 113 des ersten Halteteils 111 ist ein elektrisch leitendes Material 115 angeordnet, das bei dem dargestellten Halteteil 111 eine rechtwinklige Ausgestaltung aufweist. Das elektrisch leitende Material 115 kann beispielsweise ein Metall sein. Ein Abschnitt des elektrisch leitenden Materials 115 ragt aus dem Körper 113 so hervor, dass es in dem in Fig. 8 dargestellten Schließzustand der Haltemittel 110 mit einer an seinem Ende ausgebildeten Kontaktfläche 116 das Behandlungsgut 21 berührt. Die Kontaktflache 116 kann sowohl zum mechanischen Halten des Behandlungsgutes 21 als auch zum elektrischen Kontaktieren des Behandlungsgutes 21 dienen. An der Kontaktfläche 116 kann eine Beschichtung vorgesehen sein, die aus einem anderen Material als das elektrisch leitende Material 115 ausgebildet sein kann, beispielsweise aus einem Edelmetall, einem Mischoxid oder einem leitfähigen Elastomer.

Eine weitere elektrisch leitende Kontaktfläche 117, die mit dem elektrisch leitenden Material 115 elektrisch leitend verbunden ist, ist an einer Außenfläche des Halteteils 111 vorgesehen, die in dem in Fig. 8 dargestellten Schließzustand der Haltemittel 110 nach außen freiliegt (an der in Fig. 8 oberen Fläche des ersten Halteteils 111). Die weitere elektrische Kontaktfläche 117 kann aus einem anderen Material als das elektrisch leitende Material 115 ausgebildet sein, beispielsweise aus einem Edelmetall, einem Mischoxid oder einem leitfähigen Elastomer. Das Material für die weitere elektrische Kontaktfläche kann insbesondere derart gewählt sein, dass ein widerstandsarmer Kontakt zwischen der weiteren elektrischen Kontaktfläche 117 und dem Kontaktelement 118 besteht, mit dem in der Behandlungsanlage Strom zugeführt wird. Die weitere elektrische Kontaktfläche 117 kann so ausgebildet sein, dass sie quer zur Längsrichtung des ersten Halteteils 111, d.h. in der Breitenrichtung des Behandlungsgutes 21, breiter als die Kontaktfläche 119 des Kontaktelements 118 ist, das in der Behandlungsanlage auf die weitere elektrische Kontaktfläche 117 zum Zuführen von Strom darauf aufgedrückt wird.

Das erste Halteteil 111 kann so ausgebildet sein, dass die Kontaktfläche 116 und die weitere Kontaktfläche 117 eben ausgestaltet sind. Bei einem weiteren Ausführungsbeispiel kann die Kontaktfläche 116 und/oder die weitere Kontaktfläche 117 eine konvexe Form aufweisen. Insbesondere können die Kontaktfläche 116 und die weitere Kontaktfläche 117 mit einer konvexen Form derart ausgebildet sein, dass das Behandlungsgut 21 bzw. die Kontaktfläche 119 des Kontaktelements 118 auf einer kleineren Fläche, aber mit einer größeren Normalkraft berühren als planar ausgebildete Kontaktflächen.

In dem Körper 123 des zweiten Halteteils 112 ist ein elektrisch leitendes Material 125 angeordnet, das bei dem dargestellten Halteteil 112 eine rechtwinklige Ausgestaltung aufweist. Das elektrisch leitende Material 125 kann insbesondere ein Metall sein. Ein Abschnitt des elektrisch leitenden Materials 125 ragt aus dem Körper 123 so hervor, dass es in dem in Fig. 8 dargestellten Schließzustand der Haltemittel 110 mit einer an seinem Ende ausgebildeten Kontaktfläche 126 das Behandlungsgut 21 berührt. Die Kontaktfläche 126 kann sowohl zum mechanischen Halten des Behandlungsgutes 21 als auch zum elektrischen Kontaktieren des Behandlungsgutes 21 dienen. An der Kontaktfläche 126 kann eine Beschichtung vorgesehen sein, die aus einem anderen Material als das elektrisch leitende Material 125 ausgebildet sein kann, beispielsweise aus einem Edelmetall, einem Mischoxid oder einem leitfähigen Elastomer.

Eine weitere elektrisch leitende Kontaktfläche 127, die mit dem elektrisch leitenden Material 125 elektrisch leitend verbunden ist, ist an einer Außenfläche des Halteteils 112 vorgesehen, die in dem in Fig. 8 dargestellten Schließzustand der Haltemittel 110 nach außen freiliegt (an der in Fig. 8 unteren Fläche des zweiten Halteteils 112). Die weitere elektrische Kontaktfläche 127 kann aus einem anderen Material ausgebildet sein als das elektrisch leitende Material 125, beispielsweise aus einem Edelmetall, einem Mischoxid oder einem leitfähigen Elastomer. Das Material für die weitere elektrische Kontaktfläche 127 kann insbesondere derart gewählt sein, dass ein widerstandsarmer Kontakt zwischen der weiteren elektrischen Kontaktfläche 127 und dem Kontaktelement 128 besteht, mit der in der Behandlungsanlage Strom zugeführt wird. Die weitere elektrische Kontaktfläche 127 kann so ausgebildet sein, dass sie quer zur Längsrichtung des zweiten Halteteils 112, d.h. in der Breitenrichtung des Behandlungsgutes 21, breiter als die Kontaktfläche 129 des Kontaktelements 128 ist, die in der Behandlungsanlage auf die weitere elektrische Kontaktfläche 127 zur Stromzuführung aufgedrückt wird.

Das zweite Halteteil 112 kann so ausgebildet sein, dass die Kontaktfläche 126 und die weitere Kontaktfläche 127 eben ausgestaltet sind. Bei einem weiteren Ausführungsbeispiel kann die Kontaktfläche 126 und/oder die weitere Kontaktfläche 127 jeweils eine konvexe Form aufweisen. Insbesondere können die Kontaktfläche 126 und die weitere Kontaktfläche 127 mit einer konvexen Form derart ausgebildet sein, dass das Behandlungsgut 21 bzw. die Kontaktfläche 129 des Kontaktelements 128 auf einer kleineren Fläche, aber mit einer größeren Normalkraft berühren als planar ausgebildete Kontaktflächen.

Das elektrisch leitende Material 115 in dem ersten Halteteil 111 und das elektrisch leitende Material 125 in dem zweiten Halteteil 112 kann entlang der Längsrichtung der Haltemittel 110 durchbrochen sein. Entlang der Längsrichtung des ersten und zweiten Halteteils 111 und 112 kann das erste bzw. zweite Halteteil 111, 112 somit mehrere Segmente von elektrisch leitendem Material 115 bzw. 125 aufweisen. Alternativ kann das elektrisch leitende Material 115 und/oder 125 in dem ersten und/oder zweiten Halteteil 111, 112 auch stiftförmig vorgesehen sein. Bei einer weiteren Abwandlung kann der von dem ersten Halteteil 111 bzw. dem zweiten Halteteil 112 in Richtung des Behandlungsgutes 21 hervorragende Abschnitt des elektrisch leitenden Materials 115, 125 segmentiert oder in Form mehrerer Stifte ausgebildet sein. Derart ausgebildete Kontaktflächen können gut in eine satte Anlage mit dem Behandlungsgut 21 gebracht werden. Die Segmente oder Stifte können voneinander beabstandet oder dicht nebeneinander angereiht vorgesehen sein.

Das mit den Haltemitteln 110 gehalterte Behandlungsgut 21 kann durch eine Behandlungsanlage transportiert werden, in der in einer elektrochemischen Behandlungsstation die Kontaktelemente 118, 128 an die nach außen freiliegenden Kontaktflächen 117, 127 angepresst werden. Die Kontaktelemente können herkömmliche Kontaktelemente, beispielsweise in Form von Klammern, sein. Die Kontaktelemente können auch rollen- oder scheibenförmig ausgebildet sein. Die Kontaktelemente 118, 128 können insbesondere mit betragsmäßig gleich großen, aber entgegengesetzt gerichteten Kräften gegen die Kontaktflächen 117, 127 der Haltemittel 110 gepresst werden.

Bei einem weiteren Ausführungsbeispiel können die Haltemittel 110 so ausgebildet sein, dass anstelle einer Ausnehmung und einem in diese im Schließzustand der Haltemittel 110 eingreifenden Vorsprung, wie in Fig. 8 dargestellt, ein Scharnier vorgesehen ist, das das obere Halteteil 111 und das untere Halteteil 112 miteinander verbindet und relativ zueinander positioniert.

Auch wenn Haltemittel 22, 110 für flächiges Behandlungsgut, wie sie unter Bezugnahme auf Fig. 6-8 beschrieben wurden, zum Transport eines dünnen Behandlungsgutes mit geringer Eigensteifigkeit eingesetzt werden können, können die Haltemittel 22, 110 auch zum Haltern und/oder Kontaktieren von dickeren Substraten eingesetzt werden. Beispielsweise können die erfindungsgemäßen Haltemittel 110 auch zum Transport von Leiterplatten durch eine Galvanisierungsanlage oder dergleichen eingesetzt werden, wenn die Leiterplatten eine so hohe Eigensteifigkeit aufweisen, dass sie nicht in Breitenrichtung gespannt werden müssen.

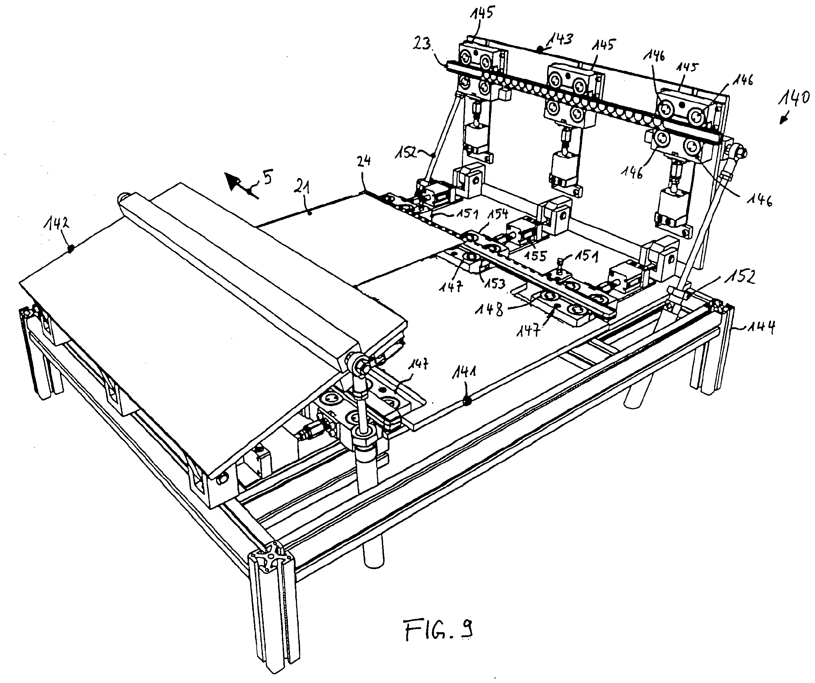

Fig. 9 ist eine Perspektivansicht einer Beladeeinrichtung 140, die bei einer Anlage nach einem Ausführungsbeispiel verwendet wird. Die Beladeeinrichtung 140 kann als Beladeeinrichtung 10 der Anlage 1 von Fig. 1 verwendet werden.

Die Beladeeinrichtung 140 ist ausgestaltet, um Haltemittel 22 mit ersten und zweiten Halteteilen 23, 24 an einem flächigen Behandlungsgut 21 anzubringen. Die Beladeeinrichtung 140 umfasst Stützmittel, die als Stützplatte 141 ausgebildet sein können. Die Stützplatte 141 kann als Lochplatte ausgebildet sein. Die Stützplatte 141 ist mit einer (nicht dargestellten) Betätigungseinrichtung höhenverstellbar. Die Beladeeinrichtung 140 umfasst weiterhin zwei Flügel 142, 143, die an einem Rahmen 144 verschwenkbar gelagert sind. Pneumatische Einrichtungen 151, 152 sind vorgesehen, um die Flügel zu öffnen und zu schließen.

An dem Rahmen 143 sind in zwei Reihen eine Mehrzahl von Führungseinrichtungen 147 angeordnet. Die Führungseinrichtungen 147 sind ausgestaltet, um das zweite Halteteil 24 der Haltemittel 22 aufzunehmen und bei einem Weitertransport der Haltemittel 22 zu führen. An jedem der Flügel 142, 143 ist eine Mehrzahl von Führungseinrichtungen 145 jeweils in einer Reihe angeordnet. Die Führungseinrichtungen 147 sind ausgestaltet, um das erste Halteteil 23 der Haltemittel 22 aufzunehmen und bei einem Weitertransport der Haltemittel 22 zu führen. Die Führungseinrichtungen 147 und die Führungseinrichtungen 145 können insbesondere so angeordnet sein, dass im geschlossenen Zustand der Flügel 142, 143 jeweils eine der Führungseinrichtungen 145 vertikal über einer der Führungseinrichtungen 145 liegt.

Die Beladeeinrichtung 140 ist ausgestaltet, um die Haltemittel 22 zwischen ihrem Schließzustand, in dem die ersten und zweiten Halteteile 23, 24 einander berühren, und ihrem Offenzustand, in dem das Behandlungsgut 21 in die Haltemittel 22 eingefügt werden kann, zu überführen. Dazu können die Führungseinrichtungen 147 ausgestaltet sein, um beim Öffnen der Flügel 142, 143 das zweite Halteteil 24 so an den Führungseinrichtungen 147 zu sichern, dass es sich nicht zusammen mit dem ersten Halteteil 23 bewegt. Die Führungseinrichtungen 145 können ausgestaltet sein, um beim Öffnen der Flügel 142, 143 das erste Halteteil 23 so an den Führungseinrichtungen 145 zu sichern, dass es sich zusammen mit dem Flügel 142 bzw. 143 von dem zweiten Halteteil 24 weg bewegt.

Wenn die ersten und zweiten Halteteile eine profilierte Außenoberfläche aufweisen, kann jede der Führungseinrichtungen 147 Eingriffsmittel 148 aufweisen, die das zweite Halteteil 24 formschlüssig halten, wenn der Flügel 142, 143 geöffnet wird. Beispielsweise können die Eingriffsmittel eine Scheibe 148 oder mehrere Scheiben 148 mit einem Außenrand umfassen, dessen Profil, beispielsweise in Form eines V-förmigen Vorsprungs, komplementär zu einem Seitenprofil des zweiten Halteteils 24 ist. Insbesondere kann jede der Führungseinrichtungen 147 wenigstens zwei Scheiben 148 mit einem Außenprofil aufweisen, das komplementär zu dem Außenprofil des zweiten Halteteils ist, wobei die zwei Scheiben 148 mit gegenüberliegenden Außenflächen des zweiten Halteteils 24 in Eingriff treten. Ähnlich kann jede der Führungseinrichtungen 145 Eingriffsmittel 146 aufweisen, die das erste Halteteil 23 formschlüssig halten. Beispielsweise können die Eingriffsmittel eine Scheibe 146 oder mehrere Scheiben 146 mit einem Außenrand umfassen, dessen Profil, beispielsweise in Form eines V-förmigen Vorsprungs, komplementär zu einem Seitenprofil des ersten Halteteils 23 ist. Insbesondere kann jede der Führungseinrichtungen 145 wenigstens zwei Scheiben 146 mit einem Außenprofil aufweisen, das komplementär zu dem Außenprofil des ersten Halteteils 23 ist, wobei die zwei Scheiben 146 mit gegenüberliegenden Außenflächen des ersten Halteteils 23 in Eingriff treten.

Nachfolgend wird der Betrieb der Beladeeinrichtung 140 beschrieben. Am Beginn eines Arbeitszyklus sind die Flügel 142, 143 geschlossen und es befinden sich keine Halteteile 23, 24 in den Führungseinrichtungen 145, 147. Die Haltemittel 22 werden im Schließzustand in die durch die Führungseinrichtungen 145, 147 definierten Führungen eingeführt. Wenn die Haltemittel 22 vollständig in die durch die Führungseinrichtungen 145, 147 definierten Führungen eingeführt sind, werden die pneumatischen Einrichtungen 151, 152 betätigt, um die Flügel 142, 143 zu öffnen. Dabei halten die Eingriffsmittel 148 das zweite Halteteil 24 an den Führungseinrichtungen 147, und die Eingriffsmittel 146 halten das erste Halteteil 23 an den Führungseinrichtungen 145. Beim Öffnen der Flügel werden die Haltemittel 22 entsprechend in den Offenzustand überführt.

Die Flügel 142, 143 werden so weit geöffnet, dass mit einem Roboter oder dergleichen das Behandlungsgut 21 zwischen den beiden von den Führungseinrichtungen 147 gehaltenen zweiten Halteteilen 24 abgelegt werden kann. Vor dem Ablegen des Behandlungsgutes 21 wird die Stützplatte 141 vertikal in eine Position verfahren, in der sie das auf die zweiten Halteteile 24 abgelegte Behandlungsgut 21 stützen kann. Die Oberfläche der Stützplatte kann dabei so angeordnet werden, dass sie sich in einer Ebene mit den Aufnahmebereichen der zweiten Halteteile 24 befindet, auf die das Behandlungsgut 21 abgelegt wird.

Durch erneute Betätigung der pneumatischen Einrichtungen 151, 152 werden die Flügel 142, 143 geschlossen, um die an den Flügeln 142, 143 gehaltenen ersten Halteteile 23 wieder in Kontakt mit den zweiten Halteteilen 24 zu bringen. So werden die Haltemittel in den Schließzustand überführt, wobei das Behandlungsgut 21 an seinen in Längsrichtung verlaufenden Randbereichen zwischen den ersten und zweiten Halteteilen 23, 24 gehalten wird.

Nachdem die Haltemittel 22 in den Schließzustand überführt wurden, wird die Stützplatte 141 abgesenkt. Das von den Haltemitteln 22 gehaltene Behandlungsgut wird aus der Beladeeinrichtung 140 transportiert. Dies kann beispielsweise durch drehendes Antreiben der scheibenförmigen Eingriffsmittel 148 der Führungseinrichtungen 147 und/oder durch drehendes Antreiben der scheibenförmigen Eingriffsmittel 146 der Führungseinrichtungen 145 erfolgen.

Bei einem Ausführungsbeispiel werden zum Transportieren der Haltemittel scheibenförmige Eingriffsmittel zumindest einer Führungseinrichtung 145 oder 147, die die an einem Längsrand des Behandlungsgutes angebrachten Haltemittel führt, und scheibenförmige Eingriffsmittel zumindest einer weiteren Führungseinrichtung 145 oder 147, die die an dem anderen Längsrand des Behandlungsgutes angebrachten weiteren Haltemittel führt, drehend angetrieben. Bei einem Ausführungsbeispiel werden an jeder Seite des Behandlungsgutes scheibenförmige Eingriffsmittel zumindest einer Führungseinrichtung 145 oder 147 drehend angetrieben, die an der äußersten Position in Transportrichtung, d.h. bei Verwendung der Beladeeinrichtung 140 in der Anlage 1 von Fig. 1 benachbart zu der Puffereinrichtung 12 angeordnet ist. Bei einem weiteren Ausführungsbeispiel werden scheibenförmige Eingriffsmittel aller Führungseinrichtungen 147 drehend angetrieben, um die Haltemittel und somit das an ihnen gehalterte Behandlungsgut zu transportieren. Zum Transportieren der Haltemittel können jeweils alle scheibenförmigen Eingriffsmittel der entsprechenden Führungseinrichtungen angetrieben werden. Bei einem Ausführungsbeispiel wird in jeder der Führungseinrichtungen nur ein Teil der scheibenförmigen Eingriffsmittel angetrieben, beispielsweise die scheibenförmigen Eingriffsmittel, die außen an den Haltemitteln anliegen, d.h. an der vom Behandlungsgut abgewandten Seite der Führungseinrichtungen 147 vorgesehen sind.

Um die Haltemittel 22 sicher zu führen, können die Führungseinrichtungen 147 bzw. 145 zwei gegeneinander verschiebbare Backen 153 und 154 aufweisen. Zwischen den Backen 153 und 154 ist eine Vertiefung vorgesehen, in die wenigstens ein Abschnitt des zweiten bzw. ersten Halteteils einfügbar ist. Eine Bewegungseinrichtung 155 ist mit wenigstens einem der Backen 153 und 154 gekoppelt, um die Backen relativ zueinander zu verstellen. Die Bewegungseinrichtung 155 kann beispielsweise als pneumatische Einrichtung ausgebildet sein, die mit dem inneren Backen 153 gekoppelt ist. Die Bewegungseinrichtung kann die Backen 153, 154 relativ zueinander so verstellen, dass die an den Backen angebrachten scheibenförmigen Eingriffsmittel 148 bzw. 146 gegen das in der Führungseinrichtung geführte Halteteil der Haltemittel gedrückt werden. Falls die scheibenförmigen Eingriffsmittel in der entsprechenden Führungseinrichtung drehend angetrieben werden, um die Haltemittel in der Transportrichtung zu transportieren, kann die Bewegungseinrichtung 155 eingerichtet sein, um die Backen 153, 154 so zu verstellen, dass bei drehendem Antrieb der scheibenförmigen Eingriffsmittel die Haltemittel 22 durch einen Reibschluss zwischen den Eingriffsmitteln der Führungseinrichtung und den Haltemitteln 22 bewegt werden. Alternativ oder zusätzlich kann auch ein Formschluss zwischen den scheibenförmigen Eingriffsmitteln der Führungseinrichtungen und den Haltemitteln derart vorgesehen sein, dass die Haltemittel bei Drehen der scheibenförmigen Eingriffsmittel bewegt werden.

Während bei dem in Fig. 9 dargestellten Ausführungsbeispiel die Führungseinrichtungen sowohl zum Führen der Haltemittel in Transportrichtung als auch zum Sichern der Halteteile der Haltemittel beim Öffnen der Flügel, um die Halteteile voneinander zu trennen, verwendet werden, können separate Einrichtungen für diese Funktionen vorgesehen werden. Beispielsweise können stiftförmige Eingriffsmittel vorgesehen sein, um die Halteteile der Haltemittel beim Öffnen der Flügel so zu sichern, dass die Halteteile voneinander getrennt werden, während die Führungseinrichtungen die Haltemittel beim Transport in Transportrichtung führen.

Die pneumatischen Einrichtungen 151, 152 öffnen die Flügel 142, 143 und wirken so als Bewegungsmittel, die eine Bewegung der Eingriffsmittel 146, die mit dem ersten Halteteil 23 in Eingriff stehen, relativ zu den Eingriffsmitteln 148, die mit dem zweiten Halteteil 24 in Eingriff stehen, hervorrufen. Die pneumatischen Einrichtungen 151, 152 können so ausgebildet sein und so betätigt werden, dass die ausgeübte Kraft bzw. das auf die Flügel 142, 143 wirkende Drehmoment jeweils mit zunehmendem Öffnungswinkel des Flügels 142, 143 abnimmt. Beispielsweise können pneumatische Druckstempel 151 vorgesehen sein, die über einen ersten Weg eine erste Kraft ausüben können, um eine Anfangsöffnung des Flügels 143 zu erzeugen und dabei die Halteteile 23, 24 der Haltemittel 22 voneinander zu lösen. Das weitere Öffnen des Flügels 143 kann durch weitere pneumatische Einrichtungen 152 oder andere Aktuatoren erfolgen, die über einen längeren Weg als die Druckstempel 151 betätigbar sind, aber nur eine kleiner Kraft ausüben.

Abwandlungen der unter Bezugnahme auf Fig. 9 beschriebenen Beladeeinrichtung 140 können bei weiteren Ausführungsbeispielen realisiert werden. Beispielsweise können die Eingriffsmittel, die das erste bzw. zweite Halteteil 23, 24 der Haltemittel 22 halten, so ausgestaltet sein, dass sie das erste bzw. zweite Halteteil kraftschlüssig halten, um die Haltemittel vom Schließzustand in den Offenzustand zu überführen. Weiterhin kann beispielsweise anstelle der höhenverstellbaren Stützplatte 141 eine Einrichtung verwendet werden, die ein Luftkissen zum Abstützen des Behandlungsgutes 21 erzeugt, beispielsweise wenn sich die Haltemittel in dem Offenzustand befinden. Weiterhin können die Haltemittel 22 vor Erreichen des Schließzustandes in einen Zustand versetzt werden, in dem sie mit einer Biegespannung parallel zu der Transportebene versehen sind:

Die unter Bezugnahme auf Fig. 9 erläuterte Einrichtung kann nicht nur als Beladeeinrichtung, sondern auch als Entladeeinrichtung verwendet werden. Dabei werden die oben beschriebenen Funktionsabläufe so umgekehrt, dass das von den Haltemitteln gehaltene Behandlungsgut der Einrichtung zugeführt wird, und die Haltemittel von dem Schließzustand in den Offenzustand überführt werden, um das Behandlungsgut von den Haltemitteln entfernen zu können. Eine derartige Entladeeinrichtung kann als Entlader 13 der Anlage 1 von Fig. 1 eingesetzt werden.

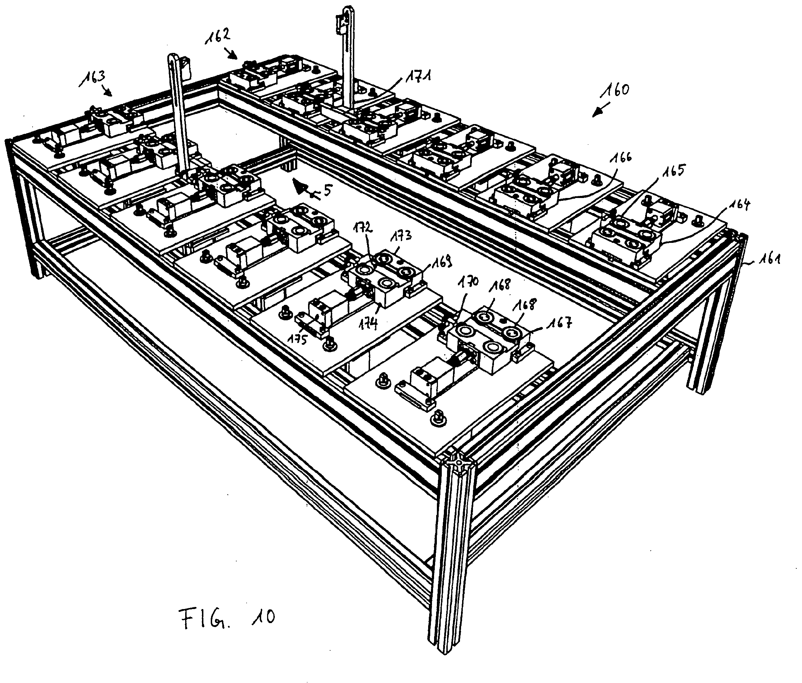

Fig. 10 ist eine Perspektivansicht einer Puffereinrichtung 160, die als Puffereinrichtung 12 oder als Puffereinrichtung 14 der Behandlungsanlage 1 von Fig. 1 verwendet werden kann.

Die Puffereinrichtung kann eingerichtet sein, um neben der Aufnahme von aus der Beladeeinrichtung ausgegebenem oder in die Entladeeinrichtung zuzuführendem Beladungsgut zusätzliche Aufgaben zu erfüllen. Wie für die Puffereinrichtung 160 nachfolgend erläutert wird, kann die Puffereinrichtung das von Haltemitteln entlang den Längsrändern gehaltene Behandlungsgut in der Richtung quer zur Transportrichtung spannen, während sie das Behandlungsgut von der Beladeeinrichtung zu der Prozesslinie transportiert. Alternativ oder zusätzlich kann die Puffereinrichtung eingerichtet sein, um einen Abstand zwischen aufeinanderfolgenden Substraten oder Behandlungsgütern einzustellen. Die Puffereinrichtung kann auch eingerichtet sein, um einen Gleichlauf zwischen den an gegenüberliegenden Längsrändern des Behandlungsgutes angebrachten Haltemitteln derart einzustellen, dass diese an gleichen Positionen entlang der Transportrichtung angeordnet sind, sich also in einem Gleichlauf befinden.

Die Puffereinrichtung 160 weist eine erste Gruppe 162 von Transporteinrichtungen und eine zweite Gruppe 163 von Transporteinrichtungen auf, die an einem Rahmen 161 angebracht sind. Jede der Transporteinrichtungen der ersten und zweiten Gruppe 162, 163 von Transporteinrichtungen ist eingerichtet, um die Haltemittel 22 zu führen und weiterzubewegen, die das Behandlungsgut 21 halten. Dazu weist jede der Transporteinrichtungen eine entsprechende Führungsnut zum Aufnehmen der Haltemittel 22 auf. Drehbar gelagerte Antriebsscheiben 165, 168 sind entlang den Führungsnuten der Transporteinrichtungen vorgesehen. Die Antriebsscheiben können paarweise an entgegengesetzten Seiten der Führungsnuten angeordnet sein. Durch drehendes Antrieben der Antriebsscheiben werden die Haltemittel in der Transportrichtung bewegt. Beispielsweise kann wenigstens eine Antriebsscheibe in jeder der Transporteinrichtungen drehend angetrieben werden, um die Haltemittel zu bewegen. Bei einem Ausführungsbeispiel wird ein Paar von Antriebsscheiben jeder Transporteinrichtung angetrieben, die außen an den Haltemitteln, d.h. an der von dem Behandlungsgut abgewandten Seite der Transporteinrichtung, an den Haltemitteln anliegen. Durch das Bewegen der Haltemittel erfolgt der Weitertransport des von den Haltemitteln gehaltenen Behandlungsgutes. Auch in der Puffereinrichtung 160 erfolgt der Transport des Behandlungsgutes somit, indem die Transporteinrichtungen 164, 166, 167, 169 die Haltemittel bewegen, an denen das Behandlungsgut gehaltert ist.

Jede der Transporteinrichtungen kann zwei gegeneinander verschiebbare Backen 173 und 174 aufweisen, zwischen denen die Führungsnut 172 ausgebildet ist. Eine Bewegungseinrichtung 175 ist mit wenigstens einem der Backen 173 oder 174 gekoppelt, um die Backen relativ zueinander zu verstellen. Ein Paar von Antriebsscheiben kann an jedem der Backen vorgesehen sein. Die Bewegungseinrichtung 175 kann beispielsweise als pneumatische Einrichtung ausgebildet sein, die mit dem inneren Backen 173 gekoppelt ist. Die Bewegungseinrichtung kann die Backen 173, 174 relativ zueinander so verstellen, dass die an den Backen angebrachten Antriebsscheiben gegen das in der Führungsnut angeordnete Halteteil der Haltemittel gedrückt werden. Die Bewegungseinrichtung 175 kann eingerichtet sein, um die Backen 173, 174 so zu verstellen, dass bei drehendem Antrieb der Antriebsscheiben die Haltemittel 22 durch einen Reibschluss zwischen den Antriebsscheiben und den Haltemitteln 22 bewegt werden. Alternativ oder zusätzlich kann auch ein Formschluss zwischen den Antriebsscheiben und den Haltemitteln 22 derart vorgesehen sein, dass die Haltemittel 22 bei Drehen der Antriebsscheiben bewegt werden.

Die Transporteinrichtungen der Gruppen 161, 162 von Transporteinrichtungen können so vorgesehen sein, dass beim Transportieren des von den Haltemitteln gehaltenen Behandlungsgutes der Abstand zwischen den Haltemitteln, die das Behandlungsgut an den entgegengesetzten Längsrändern des Behandlungsgutes halten, allmählich vergrößert wird. Dazu können die Transporteinrichtungen so angeordnet sein, dass der Abstand der Führungsnuten der Transporteinrichtungen 166, 169 größer als der Abstand der Führungsnuten der Transporteinrichtungen 164, 167 ist. Der Abstand zwischen den Führungsnuten von Transporteinrichtungen, die für die beiden seitlich am Behandlungsgut angebrachten Haltemittel vorgesehen sind, kann entlang der Transportrichtung zunehmen. Auf diese Weise kann in der Puffereinrichtung 160 das Behandlungsgut allmählich gespannt werden, während es von der Beladeeinrichtung zur Prozesslinie transportiert wird.

Um die Bewegung der Haltemittel in der Puffereinrichtung 160 zu überwachen, sind an den Transporteinrichtungen Sensoren 170 vorgesehen, die den Durchtritt der Haltemittel durch die entsprechenden Transporteinrichtungen erfassen. Weitere Sensoren 171 sind für die Einstellung des Substratabstands vorgesehen. Die Sensoren 171 könne beispielsweise einen Ist-Abstand von Haltemitteln aufeinanderfolgender Substrate bzw. Behandlungsgüter erfassen. Die an den aufeinanderfolgenden Substraten angebrachten Haltemittel können abhängig von dem ermittelten Ist-Abstand so weiterbewegt werden, dass ein gewünschter Soll-Abstand eingestellt wird.

Die Vorrichtungen, Verfahren und Haltemitteln nach verschiedenen Ausführungsbeispielen erlauben es, Behandlungsgut in einer Anlage zur chemischen und/oder elektrochemischen Behandlung des Behandlungsgutes so zu transportieren, dass ein sicherer Transport von Behandlungsgut mit geringer Eigenstabilität oder mit einer empfindlichen Oberfläche möglich ist.

Zahlreiche Abwandlungen der in den Figuren dargestellten und detailliert beschriebenen Ausführungsbeispiele können bei anderen Ausführungsbeispielen realisiert werden.

Während bei der unter Bezugnahme auf Fig. 3 und 4 beschriebenen Transportvorrichtung Loslager die an beiden Seiten des Behandlungsgutes vorgesehenen Haltemittel federnd nach außen drücken, kann bei einer Abwandlung ein Loslager für die an einem Längsrand des Behandlungsgutes angebrachte Haltemittel vorgesehen sein, während für das an dem anderen Längsrand des Behandlungsgutes angebrachte Haltemittel ein Festlager vorgesehen ist. Bei weiteren Ausführungsbeispielen kann die auf das Behandlungsgut quer zur Transportrichtung und in der Transportebene wirkende Kraft nicht durch mechanische Lager, sondern beispielsweise durch einen quer zur Transportrichtung strömenden Fluidstrom erzeugt werden.

Während im Kontext eines Ausführungsbeispiels eine Transportvorrichtung mit Transportrollen beschrieben wurde, können bei anderen Ausführungsbeispielen auch andere Transportmittel verwendet werden. Beispielsweise kann die Transportvorrichtung eine umlaufende Kette aufweisen. An den Haltemitteln, die das Behandlungsgut an seinem Längsrand halten, können Eingriffsabschnitte ausgebildet sein, die ein Einhängen der Haltemittel in die umlaufende Kette erlauben.

Die auf das Behandlungsgut quer zur Transportrichtung und in der Transportebene wirkende Kraftkomponente zum Spannen des Behandlungsgutes muss nicht durch die Transportvorrichtung bereitgestellt werden. Bei weiteren Ausführungsbeispielen können beispielsweise federelastische Elemente vorgesehen sein, die mit den zwei an die gegenüberliegenden Längsränder des Behandlungsgutes angreifenden Haltemittel gekoppelt sind und diese voneinander weg drücken. Durch das Paar von Haltemitteln und die federelastischen Elemente wird somit ein Rahmen gebildet, der das Behandlungsgut an dem Längsrand stabilisiert und in der Breitenrichtung spannt. Die federelastischen Elemente können in Breitenrichtung des Behandlungsgutes zwischen den an den gegenüberliegenden Längsrändern des Behandlungsgutes angreifenden Haltemitteln verlaufen. Die federelastischen Elemente können so ausgestaltet sein, dass sie relativ dünn sind, beispielsweise eine Dicke von weniger als 3 mm aufweisen.

Bei noch einem weiteren Ausführungsbeispiel können federelastische Elemente vorgesehen sein, die mit den zwei an die gegenüberliegenden Längsränder des Behandlungsgutes angreifenden Haltemitteln gekoppelt sind und diese voneinander weg drücken. Die federelastischen Elemente können relativ dünn sein, beispielsweise mit einer Dicke von weniger als 3 mm ausgebildet sein. Jedes der Haltemittel kann in mehrere in Längsrichtung des Behandlungsgutes beabstandete Abschnitte segmentiert sein. Zwischen den Abschnitten jedes der Haltemittel können weitere federelastische Elemente vorgesehen sein, die die Abschnitte des entsprechenden Haltemittels in der Längsrichtung des Behandlungsgutes voneinander weg drücken. Durch die Abschnitte der Haltemittel mit den federelastischen Elementen und den weiteren federelastischen Elementen wird ein komplett federnder Rahmen ausgebildet, der das Behandlungsgut sowohl in Längsrichtung als auch in Breitenrichtung spannen kann.

Während an beiden Längsrändern des Behandlungsgutes Haltemittel angebracht sein können, um das Behandlungsgut zu halten, können bei weiteren Ausführungsbeispielen Haltemittel, die das Behandlungsgut an mindestens zwei Punkten entlang dem Längsrand halten, auch nur an einem der sich parallel zur Transportrichtung erstreckenden Randbereiche des Behandlungsgutes angebracht sein.

Während Ausführungsbeispiele im Kontext von Anlagen beschrieben wurden, bei denen das Behandlungsgut in einer horizontalen Transportebene bewegt wird, können die Vorrichtungen und Verfahren ebenfalls eingesetzt werden, wenn das Behandlungsgut vertikal gerichtet transportiert wird.

Das Behandlungsgut kann in eine Behandlungsflüssigkeit getaucht sein, während es transportiert wird. Die Transportvorrichtungen und Haltemittel nach den verschiedenen Ausführungsbeispielen können entsprechend auch bei getauchtem Behandlungsgut eingesetzt werden.

Der Transport von Behandlungsgut mit geringer Eigenstabilität ist ein Anwendungsgebiet, in dem Ausführungsbeispiele der Erfindung vorteilhaft eingesetzt werden können.

Darüber hinaus können insbesondere die erfindungsgemäßen Haltemitteln auch zum Transport von Leiterplatten oder dergleichen eingesetzt werden, die eine so hohe Eigenstabilität aufweisen, dass sie beim Transport nicht quer zur Transportrichtung gespannt werden. Beispielsweise können erfindungsgemäße Haltemittel, wie sie in den Ansprüchen 22-24 angegeben sind und unter Bezugnahme auf das Ausführungsbeispiel von Fig. 8 näher beschrieben wurden, allgemein zum Transport von Substraten oder anderem Behandlungsgut in einer Elektrolyseanlage oder dergleichen verwendet werden.

### BEZUGSZEICHENLISTE

- 1: Behandlungsanlage
- 2: Prozesslinie
- 3,4: Behandlungsstation
- 5: Transportrichtung
- 6, 7: Kraftkomponente quer zur Transportrichtung
- 8: Behandlungsgut
- 9: Haltemittel
- 10: Beladeeinrichtung
- 11: mit Haltemitteln gehaltenes Behandlungsgut
- 12: Puffereinrichtung
- 13: Entladeeinrichtung
- 14: weitere Puffereinrichtung
- 15: behandeltes Behandlungsgut
- 16: Haltemittel
- 21: Behandlungsgut
- 22, 25: Haltemittel
- 22a, 22b: Haltemittel
- 23, 26: erstes Halteteil
- 24, 27: zweites Halteteil
- 28, 29: abgeschrägte Oberflächen
- B: Breite Behandlungsgut
- BR: Breite Randbereich
- L: Länge Behandlungsgut
- LH: Länge Haltemittel
- 31: Detailansicht
- 32, 33: Kontaktkante
- 34, 35: Flüssigkeitsdurchlass
- 41: Transportvorrichtung
- 42, 43: Rollenbahn
- 44, 44': Andrückrolle
- 45, 45': Loslager (Rolle mit Nut)
- 46: Zahnräder
- 47: Lagereinsatz
- 48: Ausnehmung
- 51, 52: Welle
- 53: Führungsnut
- 54, 55: Magnet
- 56: Magnethalterung
- 57: Spannkraft
- 61: Anschlagelement
- 62: Drehmitnehmer
- 63: Gewicht
- 64: Kupplung
- 71: Behandlungsstation
- 72, 73: Abschnitt Transportvorrichtung
- 75: Zuführbereich
- 76, 77: weiterer Zuführbereich
- 81: Körper
- 82: Kontaktkante
- 83: Nut
- 84: Versteifungskern
- 85: Magnet
- 86: Körper
- 87: Profil
- 91: Körper
- 93: Vorsprung
- 94: Versteifungskern
- 95: Magnet
- 96: Körper
- 97: Profil
- 101-104: Endbereich des Halteteils
- 110: Haltemittel
- 111, 112: Halteteil
- 113: Körper
- 114: Magnet
- 115: elektrisch leitendes Material
- 116, 117: Kontaktfläche
- 118: Kontaktelement
- 119: Kontaktfläche
- 123: Körper
- 124: Magnet
- 125: elektrisch leitendes Material
- 126, 127: Kontaktfläche
- 128: Kontaktelement
- 129: Kontaktfläche
- 130: Durchlass
- 140: Beladeeinrichtung
- 141: Stütztisch
- 142, 143: Flügel
- 144: Rahmen
- 145, 147: Führungseinrichtung
- 146, 148: Eingriffsmittel
- 151, 152: pneumatische Einrichtungen
- 153, 154: Backen der Führungseinrichtung
- 155: Bewegungseinrichtung
- 160: Puffereinrichtung
- 161: Rahmen
- 162, 163: Gruppe von Transporteinrichtungen
- 164, 166, 167, 169: Transporteinrichtung
- 165, 168: Antriebsscheiben
- 170, 171: Sensor
- 172: Führungsnut
- 173, 174: Backen der Transporteinrichtung
- 175: Bewegungseinrichtung
- 176: Kopplung

## Patentansprüche

1. Verfahren zum Transportieren eines flächigen Behandlungsgutes (21) in einer Anlage zur chemischen und/oder elektrochemischen Behandlung des Behandlungsgutes (21), wobei das Behandlungsgut (21) in einer Transportebene in einer Transportrichtung (5) transportiert wird, umfassend die Schritte
Anbringen von Haltemitteln (22; 110) an dem Behandlungsgut, die das Behandlungsgut (21) an mindestens zwei Punkten eines Randbereiches des Behandlungsgutes (21) halten, der beim Transportieren des Behandlungsgutes (21) entlang der Transportrichtung (5) gerichtet ist, und
Bewegen der Haltemittel (22; 110) in der Transportrichtung (5), wobei die das Behandlungsgut (21) haltenden Haltemittel (22; 110) lösbar mit einer Transportvorrichtung (41) der Anlage (1) gekoppelt werden, um das Behandlungsgut (21) zu transportieren,
wobei wenigstens während eines Abschnitts des Transportierens des Behandlungsgutes (21) auf wenigstens einen Bereich des Behandlungsgutes (21) eine Kraft mit einer Kraftkomponente (6, 7), die in der Transportebene liegt und quer zu der Transportrichtung (5) gerichtet ist, ausgeübt wird.

2. Verfahren nach Anspruch 1,
wobei weitere Haltemittel (25) das Behandlungsgut (21) an einem weiteren Randbereich des Behandlungsgutes (21) halten, wobei auf die Haltemittel (22) und die weiteren Haltemittel (25) Kräfte (6, 7) in entgegengesetzte Richtungen ausgeübt werden.

3. Verfahren nach einem der vorhergehenden Ansprüche,
wobei das Behandlungsgut (21) für eine elektrochemische Behandlung über die Haltemittel (110) elektrisch kontaktiert wird.

4. Verfahren nach einem der vorhergehenden Ansprüche,
wobei das Behandlungsgut ein Behandlungsgut (21) mit geringer Eigensteifigkeit, insbesondere eine Folie, oder eine Leiterplatte ist.

5. Haltemittel zum Transportieren eines flächigen Behandlungsgutes (21),
wobei die Haltemittel (22; 110) eingerichtet sind, um das Behandlungsgut (21) in einem Randbereich des Behandlungsgutes (21) an mindestens zwei Punkten zu halten, und wobei die Haltemittel (22; 110) für eine lösbare Kopplung mit einer Transportvorrichtung (41) einer Anlage zur chemischen und/oder elektrochemischen Behandlung des Behandlungsgutes (21) zum Transport des Behandlungsgutes (21) entlang einer Transportrichtung (5) eingerichtet und ausgestaltet sind, **dadurch gekennzeichnet, dass** sie in einem mit der Transportvorrichtung (41) gekoppelten Zustand der Haltemittel (22; 110) das Behandlungsgut (21) so zu halten, dass sich der Randbereich des Behandlungsgutes (21), in dem die Haltemittel (22; 110) das Behandlungsgut (21) halten, entlang der Transportrichtung (5) erstreckt.

6. Haltemittel nach Anspruch 5,
umfassend wenigstens einen Halteabschnitt (82; 116, 126) zum Halten des Behandlungsgutes (21), der sich entlang einer Richtung erstreckt, die in dem mit der Transportvorrichtung gekoppelten Zustand der Haltemittel (22; 110) der Transportrichtung (5) entspricht, oder eine Mehrzahl von Halteabschnitten (82; 116, 126) zum Halten des Behandlungsgutes (21), die entlang der Richtung angeordnet sind, die in dem mit der Transportvorrichtung gekoppelten Zustand der Haltemittel (22; 110) der Transportrichtung (5) entspricht.

7. Haltemittel nach Anspruch 5 oder 6, umfassend
ein erstes Halteteil (23; 111) und ein zweites Halteteil (24; 112), die einen Schließzustand zum Haltern des Behandlungsgutes (21) und einen Offenzustand zum Einfügen des Behandlungsgutes (21) aufweisen und eingerichtet sind, um in dem Schließzustand das Behandlungsgut (21) wenigstens durch einen Kraftschluss, insbesondere einen Reibschluss, zwischen dem ersten Halteteil (23; 111) und dem zweiten Halteteil (24; 112) zu halten, und
Positionierungsmittel (83, 93), um das erste Halteteil (23; 111) und das zweite Halteteil (24; 112) in dem Schließzustand in einer vorgegebenen Anordnung zueinander zu positionieren.

8. Haltemittel nach einem der Ansprüche 5-7,
welche eine Halteschiene (23, 24; 111) umfassen, in der Durchlässe (88, 89; 130) für eine Flüssigkeit ausgebildet sind.

9. Vorrichtung zum Transportieren eines mit Haltemitteln (22; 110) entlang einem Randbereich gehalterten flächigen Behandlungsgutes (21) für eine Anlage (1) zur chemischen und/oder elektrochemischen Behandlung des Behandlungsgutes (21), wobei die Vorrichtung (41) eingerichtet ist, um das Behandlungsgut (21) in einer Transportebene in einer Transportrichtung (5) zu transportieren, umfassend Transportmittel (44, 45), die lösbar mit den Haltemitteln (22; 110) koppelbar sind und die eingerichtet und **dadurch gekennzeichnet** sind, die Haltemittel (22; 110) mit dem daran gehalterten Behandlungsgut (21) in der Transportrichtung (5) so zu bewegen, dass sich ein Randbereich des Behandlungsgutes (21), in dem die Haltemittel (22; 110) das Behandlungsgut (21) halten, entlang der Transportrichtung (5) erstreckt,
wobei die Vorrichtung (41) eingerichtet ist, um wenigstens während eines Abschnitts des Transportierens des Behandlungsgutes (21) auf wenigstens einen Bereich des Behandlungsgutes (21) eine Kraft mit einer Kraftkomponente (6, 7), die in der Transportebene liegt und quer zu der Transportrichtung (5) gerichtet ist, auszuüben.

10. Vorrichtung nach Anspruch 9,
umfassend Spannmittel (45, 54, 55) zum Ausüben einer Kraft (57) auf die Haltemittel (22; 110), die in der Transportebene und quer zu der Transportrichtung (5) gerichtet ist,, wobei die Spannmittel ein Loslager (45) zum Führen der Haltemittel (22; 110) umfassen, und
wobei die Transportmittel eine Antriebswelle (52) umfassen, an der das Loslager (45) angebracht ist.

11. Vorrichtung nach Anspruch 9,
umfassend Spannmittel (45, 54, 55) zum Ausüben einer Kraft (57) auf die Haltemittel (22; 110), die in der Transportebene und quer zu der Transportrichtung (5) gerichtet ist, wobei die Spannmittel ein Loslager (45) zum Führen der Haltemittel (22; 110) umfassen, und
wobei die Spannmittel Kraftmittel (54, 55), insbesondere mindestens einen Magneten, umfassen, um auf das Loslager (45) eine Kraft (57) quer zu der Transportrichtung (5) auszuüben.

12. Vorrichtung nach Anspruch 9,
umfassend Spannmittel (45, 54, 55) zum Ausüben einer Kraft (57) auf die Haltemittel (22; 110), die in der Transportebene und quer zu der Transportrichtung (5) gerichtet ist, wobei die Vorrichtung eingerichtet ist, um das Behandlungsgut (21) zu transportieren, das entlang einem weiteren Randbereich mit weiteren Haltemitteln (25) gehaltert ist, wobei die Vorrichtung weitere Spannmittel (45') umfasst, die eingerichtet sind, um auf die weiteren Haltemittel (25) eine Kraft auszuüben die in der Transportebene und quer zu der Transportrichtung (5) gerichtet ist.

13. System zum Transportieren eines flächigen Behandlungsgutes (21) für eine Anlage zur chemischen und/oder elektrochemischen Behandlung des Behandlungsgutes (21), umfassend
eine Vorrichtung (41) nach einem der Ansprüche 9-12 und
Haltemittel (22; 110), die mit dem Randbereich des Behandlungsgutes (21) koppelbar sind,
wobei die Transportmittel der Vorrichtung lösbar mit den Haltemitteln (22; 110) gekoppelt sind.

14. System nach Anspruch 13, umfassend
eine Be- oder Entladeeinrichtung für die Anlage zur chemischen und/oder elektrochemischen Behandlung des Behandlungsgutes (21),
wobei die Be- oder Entladeeinrichtung (140) eingerichtet ist, um die Haltemittel (22; 110) zwischen einem Schließzustand zum Halten des Behandlungsgutes (21) und einem Offenzustand zu überführen, und eine Stützeinrichtung (141)zum Abstützen des Behandlungsgutes (21), wenn die Haltemittel (22; 110) in den Offenzustand überführt sind, umfasst.

15. System nach Anspruch 14,
wobei die Be- oder Entladeeinrichtung eingerichtet ist, um die Haltemittel (22; 110) in dem Schließzustand zu empfangen, von dem Schließzustand in den Offenzustand und anschließend zurück in den Schließzustand zu überführen und in dem Schließzustand auszugeben.

## Claims

1. Method for transporting a flat material to be treated (21) within an installation for the chemical and/or electrochemical treatment of the material to be treated (21), wherein the material to be treated (21) is transported within a plane of transport in a direction of transport (5), comprising the steps:
attaching holding means (22; 110) to the material to be treated, which hold the material to be treated (21) at at least two points of an edge region of the material, which edge region is directed along the direction of transport (5) when the material to be treated (21) is being transported; and
moving of the holding means (22; 110) in the direction of transport (5), wherein the holding means (22; 110) holding the material to be treated (21) are detachably coupled to a transporting device (41) of the installation (1), in order to transport the material to be treated (21);
wherein at least during a portion of the transportation of the material to be treated (21), a force having a component (6, 7) which lies within the plane of transport and is directed transversely to the direction of transport (5), is exerted upon at least one region of the material to be treated (21).

2. Method according to claim 1,
wherein further holding means (25) hold the material to be treated (21) at a further edge region of the material to be treated (21), wherein forces (6, 7) are exerted upon the holding means (22) and the further holding means (25) in opposite directions.

3. Method according to any one of the preceding claims,
wherein electrical contact with the material to be treated (21) is made via the holding means (110) for an electrochemical treatment.

4. Method according to any one of the preceding claims,
wherein the material to be treated is a material to be treated (21) having low inherent stiffness, in particular a foil, or is a printed circuit board.

5. Holding means for transporting a flat material to be treated (21),
wherein the holding means (22; 110) are configured to hold the material to be treated (21) in an edge region of the material at at least two points, and wherein the holding means (22; 110) are configured and designed for being detachably coupled to a transporting device (41) of an installation for the chemical and/or electrochemical treatment of the material to be treated (21) for transporting the material to be treated (21) along a direction of transport (5),
**characterized in that**
the holding means hold the material to be treated (21), when the holding means (22; 110) are in a state in which they are coupled to the transporting device (41), in such a way that the edge region of the material to be treated (21), in which the holding means (22; 110) hold the material to be treated (21), extends along the direction of transport (5) .

6. Holding means according to claim 5,
comprising at least one holding portion (82; 116, 126) for holding the material to be treated (21), which portion extends along a direction which corresponds, when the holding means (22; 110) are in the state in which they are coupled to the transporting device, to the direction of transport (5), or a plurality of holding portions (82; 116, 126) for holding the material to be treated (21), which portions are arranged along the direction which corresponds, when the holding means (22; 110) are in the state in which they are coupled to the transporting device, to the direction of transport (5).

7. Holding means according to claim 5 or 6, comprising
a first holding part (23; 111) and a second holding part (24; 112), which parts have a closed condition for holding the material to be treated (21) and an open condition for the insertion of the material to be treated (21), and are configured to hold the material to be treated (21), when in the closed condition, at least by means of a force-locking connection, in particular a friction-locking connection, between the first holding part (23; 111) and the second holding part (24; 112); and
positioning means (83, 93) in order to position the first holding part (23; 111) and the second holding part (24; 112) in a predetermined arrangement in relation to one another when in the closed condition.

8. Holding means according to any one of claims 5-7,
which comprise a holding rail (23, 24; 111) in which passages (88, 89; 130) for a liquid are formed.

9. Device for transporting a flat material to be treated (21), which is mounted along an edge region by means of holding means (22; 110), for an installation (1) for the chemical and/or electrochemical treatment of the material to be treated (21),
wherein the device is configured to transport the material to be treated (21) within a plane of transport in a direction of transport (5), comprising:
transporting means (44, 45) which can be coupled to the holding means (22; 110) in a detachable manner and which are configured and **characterized in that** they move the holding means (22; 110), with the material to be treated (21) mounted thereon, in the direction of transport (5) such that an edge region of the material to be treated (21), in which the holding means (22; 110) hold the material to be treated (21), extends in the direction of transport (5);
wherein the device (41) is configured to exert, at least during a portion of the transportation of the material to be treated (21), a force having a component (6, 7) which lies within the plane of transport and is directed transversely to the direction of transport (5), upon at least one region of the material to be treated (21).

10. Device according to claim 9,
comprising tensioning means (45, 54, 55) for exerting, upon the holding means (22; 110), a force (57) which is directed within the plane of transport and transversely to the direction of transport (5);
wherein the tensioning means comprise a movable bearing (45) for guiding the holding means (22; 110); and wherein the transporting means comprise a driving shaft (52) to which the movable bearing (45) is attached.

11. Device according to claim 9,
comprising tensioning means (45, 54, 55) for exerting, upon the holding means (22; 110), a force (57) which is directed within the plane of transport and transversely to the direction of transport (5);
wherein the tensioning means comprise a movable bearing (45) for guiding the holding means (22; 110); and wherein the tensioning means comprise force means (54, 55), in particular at least one magnet, in order to exert a force (57) upon the movable bearing (45) transversely to the direction of transport (5).

12. Device according to claim 9,
comprising tensioning means (45, 54, 55) for exerting, upon the holding means (22; 110), a force (57) which is directed within the plane of transport and transversely to the direction of transport (5);
wherein the device is configured to transport the material to be treated (21) which is mounted along a further edge region by means of further holding means (25);
wherein the device comprises further tensioning means (45') which are configured to exert, upon the further holding means (25), a force which is directed within the plane of transport and transversely to the direction of transport (5) .

13. System for transporting a flat material to be treated (21) for an installation for the chemical and/or electrochemical treatment of the material to be treated (21), comprising:
a device (41) according to any one of claims 9-12; and
holding means (22; 110) which can be coupled to the edge region of the material to be treated (21);
wherein the transporting means of the device are coupled to the holding means (22; 110) in a detachable manner.

14. System according to claim 13, comprising
a loading or unloading apparatus for the installation for the chemical and/or electrochemical treatment of the material to be treated (21);
wherein the loading or unloading apparatus (140) is configured to transfer the holding means (22; 110) between a closed condition for holding the material to be treated (21) and an open condition, and comprises a supporting apparatus (141) for supporting the material to be treated (21) when the holding means (22; 110) are transferred into the open condition.

15. System according to claim 14,
wherein the loading or unloading apparatus is configured to receive the holding means (22; 110) in the closed condition, transfer them from the closed condition into the open condition and then back into the closed condition, and to pass them out in the closed condition.

## Revendications

1. Procédé de transport d'un produit à traiter (21) plat dans une installation de traitement chimique et/ou électrochimique du produit à traiter (21), dans lequel le produit à traiter (21) est transporté dans un plan de transport dans une direction de transport (5), comprenant les étapes suivantes
mise en place de moyens de maintien (22 ; 110) au niveau du produit à traiter, qui maintiennent le produit à traiter (21) au niveau d'au moins deux points d'une zone périphérique du produit à traiter (21) qui, pendant le transport du produit à traiter (21), est dirigée le long de la direction de transport (5), et
déplacement des moyens de maintien (22 ; 110) dans la direction de transport (5), dans lequel les moyens de maintien (22 ; 110) maintenant le produit à traiter (21) sont couplés de manière amovible à un dispositif de transport (41) de l'installation (1) pour transporter le produit à traiter (21),
dans lequel, au moins pendant une partie du transport du produit à traiter (21), une force est exercée sur au moins une zone du produit à traiter (21) avec une composante de force (6, 7) qui se trouve dans le plan de transport et qui est dirigée transversalement à la direction de transport (5).

2. Procédé selon la revendication 1,
dans lequel des moyens de maintien supplémentaires (25) maintiennent le produit à traiter (21) au niveau d'une autre zone périphérique du produit à traiter (21), dans lequel des forces (6, 7) sont exercées dans des directions opposées sur les moyens de maintien (22) et les moyens de maintien supplémentaires (25).

3. Procédé selon l'une des revendications précédentes,
dans lequel le produit à traiter (21) est en contact électrique par l'intermédiaire des moyens de maintien (110) pour un traitement électrochimique.

4. Procédé selon l'une des revendications précédentes,
dans lequel le produit à traiter est un produit à traiter (21) avec une faible rigidité intrinsèque, en particulier un film, ou un circuit imprimé.

5. Moyens de maintien pour le transport d'un produit à traiter (21) plat,
dans lesquels les moyens de maintien (22 ; 110) sont adaptés pour maintenir le produit à traiter (21) au niveau d'au moins deux points dans une zone périphérique du produit à traiter (21), et
dans lesquels les moyens de maintien (22 ; 110) sont adaptés et agencés pour un accouplement amovible avec un dispositif de transport (41) d'une installation de traitement chimique et/ou électrochimique du produit à traiter (21) en vue du transport du produit à traiter (21) le long d'une direction de transport (5), **caractérisés en ce que**, dans un état où les moyens de maintien (22 ; 110) sont couplés au dispositif de transport (41), ils maintiennent le produit à traiter (21) de telle sorte que la zone périphérique du produit à traiter (21) dans laquelle les moyens de maintien (22 ; 110) maintiennent le produit à traiter (21) s'étend le long de la direction de transport (5).

6. Moyens de maintien selon la revendication 5,
comprenant au moins une section de maintien (82 ; 116, 126) pour maintenir le produit à traiter (21) qui s'étend le long d'une direction correspondant à la direction de transport (5), dans l'état où les moyens de maintien (22 ; 110) sont couplés au dispositif de transport, ou une pluralité de sections de maintien (82 ; 116, 126) pour maintenir le produit à traiter (21), qui sont disposées le long de la direction correspondant à la direction de transport (5), dans l'état où les moyens de maintien (22 ; 110) sont couplés au dispositif de transport.

7. Moyens de maintien selon la revendication 5 ou 6, comprenant
une première partie de maintien (23 ; 111) et une seconde partie de maintien (24 ; 112) qui présentent un état fermé pour maintenir le produit à traiter (21) et un état ouvert pour insérer le produit à traiter (21) et qui sont adaptés pour, à l'état fermé, maintenir le produit à traiter (21) au moins par une coopération de forces, en particulier par une liaison par friction, entre la première partie de maintien (23 ; 111) et la seconde partie de maintien (24 ; 112), et
des moyens de positionnement (83, 93) pour, à l'état fermé, positionner la première partie de maintien (23 ; 111) et la seconde partie de maintien (24 ; 112) l'une par rapport à l'autre dans un agencement prédéterminé.

8. Moyens de maintien selon l'une des revendications 5 à 7,
qui comprennent un rail de maintien (23, 24 ; 111) dans lequel sont formés des passages (88, 89 ; 130) pour un liquide.

9. Dispositif de transport d'un produit à traiter (21) plat maintenu par des moyens de maintien (22 ; 110) le long d'une zone périphérique, pour une installation (1) de traitement chimique et/ou électrochimique du produit à traiter (21),
dans lequel le dispositif (41) est adapté pour transporter le produit à traiter (21) dans un plan de transport dans une direction de transport (5), comprenant
des moyens de transport (44, 45) qui peuvent être couplés de manière amovible aux moyens de maintien (22 ; 110) et qui sont adaptés et **caractérisés en ce qu'**ils déplacent les moyens de maintien (22 ; 110) avec le produit à traiter (21) maintenu sur eux dans la direction de transport (5), de telle sorte qu'une zone périphérique du produit à traiter (21) dans laquelle les moyens de maintien (22 ; 110) maintiennent le produit à traiter (21) s'étend le long de la direction de transport (5),
dans lequel le dispositif (41) est adapté pour, au moins pendant une partie du transport du produit à traiter (21), exercer sur au moins une zone du produit à traiter (21) une force avec une composante de force (6, 7) qui se trouve dans le plan de transport et est dirigée transversalement par rapport à la direction de transport (5).

10. Dispositif selon la revendication 9,
comprenant des moyens de serrage (45, 54, 55) pour exercer sur les moyens de maintien (22 ; 110) une force (57) qui est dirigée dans le plan de transport et transversalement à la direction de transport (5),
dans lequel les moyens de serrage comprennent un palier libre (45) pour guider les moyens de maintien (22 ; 110), et
dans lequel les moyens de transport comprennent un arbre d'entraînement (52) sur lequel est placé le palier libre (45).

11. Dispositif selon la revendication 9,
comprenant des moyens de serrage (45, 54, 55) pour exercer sur les moyens de maintien (22 ; 110) une force (57) qui est dirigée dans le plan de transport et transversalement à la direction de transport (5),
dans lequel les moyens de serrage comprennent un palier libre (45) pour guider les moyens de maintien (22 ; 110), et
dans lequel les moyens de serrage comprennent des moyens de force (54, 55), en particulier au moins un aimant, pour exercer une force (57) sur le palier libre (45) transversalement à la direction de transport (5).

12. Dispositif selon la revendication 9,
comprenant des moyens de serrage (45, 54, 55) pour exercer sur les moyens de maintien (22 ; 110) une force (57) qui est dirigée dans le plan de transport et transversalement à la direction de transport (5),
dans lequel le dispositif est adapté pour transporter le produit à traiter (21) qui est maintenu le long d'une autre zone périphérique avec des moyens de maintien supplémentaires (25),
dans lequel le dispositif comprend des moyens de serrage supplémentaires (45') qui sont adaptés pour exercer sur les moyens de maintien supplémentaires (25) une force dirigée dans le plan de transport et transversalement à la direction de transport (5).

13. Système de transport d'un produit à traiter (21) plat pour une installation de traitement chimique et/ou électrochimique du produit à traiter (21) comprenant
un dispositif (41) selon l'une des revendications 9 à 12, et
des moyens de maintien (22 ; 110) qui peuvent être couplés à la zone périphérique du produit à traiter (21),
dans lequel les moyens de transport du dispositif sont couplés de manière amovible aux moyens de maintien (22 ; 110).

14. Système selon la revendication 13, comprenant
un dispositif de chargement ou de déchargement pour l'installation de traitement chimique et/ou électrochimique du produit à traiter (21),
dans lequel le moyen de chargement ou de déchargement (140) est adapté pour transférer les moyens de maintien (22 ; 110) entre un état fermé pour maintenir le produit à traiter (21) et un état ouvert, et comprend un dispositif de support (141) pour supporter le produit à traiter (21) lorsque les moyens de maintien (22 ; 110) sont transférés dans l'état ouvert.

15. Système selon la revendication 14,
dans lequel le dispositif de chargement ou de déchargement est adapté pour recevoir les moyens de maintien (22 ; 110) à l'état fermé, transférer de l'état fermé à l'état ouvert puis revenir à l'état fermé, et sortir à l'état fermé.
